# EUROPEAN PATENT SPECIFICATION

(11) **EP 1 052 661 B1**
(45) Date of publication and mention of the grant of the patent: **02.11.2011**
(21) Application number: 00110055.1
(22) Date of filing: 12.05.2000
(51) Int. Cl.: H01G 9/20, C07F 15/00

(54) **Metal complex dye for a photoelectrochemical cell**
Metallkomplex-Farbstoff für eine photoelektrochemische Zelle
Colorant de complexes métalliques pour des cellules photoélectrochimiques

(30) Priority: 14.05.1999 JP 13502599; 18.06.1999 JP 17326999
(43) Date of publication of application: 15.11.2000
(73) Proprietor: FUJIFILM Corporation, Minato-ku Tokyo (JP)
(72) Inventor: Takizawa, Hiroo, c/o Fuji Photo Film Co., Ltd., Minami-Shigara-shi, Kanagawa-ken (JP)
(74) Representative: Grünecker, Kinkeldey, Stockmair & Schwanhäusser

(56) References cited:
- WO-A-97/41122
- WO-A-98/50393
- DE-U- 9 312 084
- NAZEERUDDIN M K ET AL: "CONVERSION OF LIGHT INTO ELECTRICITY WITH TRINUCLEAR RUTHENIUM COMPLEXES ADSORBED ON TEXTURED TIO2 FILMS" HELVETICA CHIMICA ACTA, VERLAG HELVETICA CHIMICA ACTA. BASEL, CH, vol. 73, 1990, pages 1788-1803, XP000828141 ISSN: 0018-019X
- BALZANI V ET AL: "Harvesting sunlight by artificial supramolecular antennae" SOLAR ENERGY MATERIALS AND SOLAR CELLS, ELSEVIER SCIENCE PUBLISHERS, AMSTERDAM, NL, vol. 38, no. 1/4, 1 August 1995 (1995-08-01), pages 159-173, XP004005363 ISSN: 0927-0248
- BIGNOZZI C A ET AL: "DESIGN OF SUPRAMOLECULAR SYSTEMS FOR SPECTRAL SENSITIZATION OF SEMICONDUCTORS" SOLAR ENERGY MATERIALS AND SOLAR CELLS, ELSEVIER SCIENCE PUBLISHERS, AMSTERDAM, NL, vol. 32, no. 3, 1 March 1994 (1994-03-01), pages 229-244, XP000429669 ISSN: 0927-0248
- CREDI A ET AL: "PHOTOPHYSICAL PROPERTIES OF A DINUCLEAR RACK-TYPE RU(II) COMPLEX AND OF ITS COMPONENTS" CHEMICAL PHYSICS LETTERS, NORTH-HOLLAND, AMSTERDAM, NL, vol. 243, no. 1/2, 8 September 1995 (1995-09-08), pages 102-107, XP001074705 ISSN: 0009-2614
- COLA DE L ET AL: "DINUCLEAR COMPLEXES OF RU AND OS CONTAINING A RIGID BRIDGING LIGAND: PHOTOPHYSICAL PROPERTIES AND PHOTOINDUCED ENERGY TRANSFER" MOLECULAR CRYSTALS AND LIQUID CRYSTALS, GORDON AND BREACH, LONDON, GB, vol. 234, 24 August 1992 (1992-08-24), pages 115-120, XP008003680 ISSN: 0026-8941
- JURIS A ET AL: "RU(II) POLYPYRIDINE COMPLEXES: PHOTOPHYSICS, PHOTOCHEMISTRY, ELECTROCHEMISTRY AND CHEMILUMINESCENCE" COORDINATION CHEMISTRY REVIEWS, ELSEVIER SCIENCE, AMSTERDAM, NL, vol. 84, 1988, pages 85-277, XP008007404 ISSN: 0010-8545

## Description

### BACKGROUND OF THE INVENTION

The present invention relates to a metal complex dye, a photoelectric conversion device comprising semiconductor particles sensitized by the metal complex dye, and a photoelectric cell comprising the photoelectric conversion device.

Solar cells for the solar power generation comprising a monocrystalline silicon, a polycrystalline silicon, an amorphous silicon, cadmium telluride, indium copper selenide, etc. have been the subject of practical use and a major object of research and development. However, for a widespread use of the solar cell as a home power source, etc., there are such problems as a high production cost, difficulty in security of raw materials, and a long energy payback time, therefore, these obstacles must be overcome. On the other hand, a variety of solar cells comprising organic materials are proposed with the objects of increasing the surface area of the cell, lowering the price thereof, etc. However, they generally have such defects as a low conversion efficiency and a poor durability.

Under these circumstances, Nature, vol. 353, pp. 737 to 740 (1991), United States Patent No. 4,927,721 and WO 94/04497 proposed a wet-type photoelectric conversion device and a solar cell each comprising a titanium dioxide porous thin film spectrally sensitized with a ruthenium complex dye as a working electrode, and materials and a production technique for making the same. The primary advantage for the wet-type device is that a low-priced photoelectric conversion device can be provided because an inexpensive oxide semiconductor such as titanium dioxide can be used without purification thereof to a high purity. The secondary advantage therefor is that a light in almost whole visible wavelength region can be converted to electricity because the dye used therein exhibits a broad absorption spectrum.

However, known ruthenium complex dyes are disadvantageous in hardly absorbing an infrared ray with a wavelength of 700 nm or more. Consequently, a photoelectric conversion device comprising such a dye exhibits a low photoelectric conversion efficiency at infrared region. It has been desired to develop a dye having a high absorbancy at a large wave range containing visible region to infrared region.

Balzani et al. describe Ruthenium-metal complex dyes.

DE 93 12 084 U relates to a photoelectric conversion device comprising semiconductor fine particles sensitized by a metal complex.

### OBJECT AND SUMMARY OF THE INVENTION

An object of the present invention is to provide a metal complex dye having a high absorbability not only at visible region but also at infrared region, which is able to efficiently sensitize semiconductor particles, a photoelectric conversion device comprising the metal complex dye which exhibits an excellent photoelectric conversion efficiency, and a photoelectric cell comprising the photoelectric conversion device.

As a result of intense research in view of the above object, the inventor has found that a metal complex dye comprising two or more metal atoms, a ligand having two or more moieties for bidentate or tridentate coordination to the metal atoms, and optional bidentate or tridentate ligand having nitrogen atoms for coordinating to the metal atom and monodentate or bidentate ligand(s) which coordinates to the metal atom via a dithiocarbamate group, a thiocyanate group, etc. has a high absorbancy in not only at visible region but also at long wavelength region and can efficiently sensitize semiconductor particles, and that a photoelectric conversion device comprising the metal complex dye exhibits an excellent photoelectric conversion efficiency, so that it is useful for a photoelectric cell. The present invention has been accomplished by the findings. The object of the present invention is solved on the basis of claims 1 to 8.

Thus, the present invention provides the photoelectric conversion device comprising semiconductor particles sensitized by the metal complex dye represented by the following general formula (I):

(LL₁)ₘ₁(X₁)ₘ₂M₁(BL)M₂(LL₂)ₘ₃(X₂)ₘ₄·Cl (I)

wherein M₁ and M₂ independently represent a metal atom;

LL₁ and LL₂ independently represent a bidentate ligand represented by the following general formula (II): 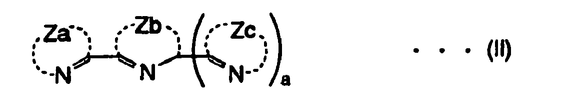 wherein Za, Zb and Zc independently represent nonmetallic atoms forming a 5- or 6-membered ring, *a* being 0;

X₁ and X₂ independently represent a monodentate or bidentate ligand which coordinates to said metal atom via one or two groups selected from the group consisting of an acyloxy group, an acylthio group, a thioacyloxy group, a thioacylthio group, an acylaminooxy group, a thiocarbamate group, a dithiocarbamate group, a thiocarbonate group, a dithiocarbonate group, a trithiocarbonate group, an acyl group, a thiocyanate group, an isothiocyanate group, a cyanate group, an isocyanate group, a cyano group, an alkylthio group, an arylthio group, an alkoxy group and an aryloxy group, or a monodentate or bidentate ligand selected from the group consisting of halogen atoms, carbonyl, dialkylketones, 1,3-diketones, carbonamides, thiocarbonamides and thioureas;
m1 and m3 independently represent 0 or 1;
m2 represents an integer of 0 to 4, and X₁'s may be the same or different ligands that may be bonded together when m2 is 2 or more;
m4 represents an integer of 0 to 4, and X₂'s may be the same or different ligands that may be bonded together when m4 is 2 or more; and
CI represents a counter ion optionally contained to neutralize charge of said metal complex dye.

The photoelectric cell of the present invention is characterized by the use of the photoelectric conversion device.

With respect to the metal complex dye, the photoelectric conversion device and the photoelectric cell of the present invention, the absorbancy at the long wavelength region and the photoelectric conversion efficiency are further improved by satisfying at least one of the following conditions (1) to (23).
(1) M₁ and M₂ is Ru.
(2) BL is represented by any one of the following general formulae B-1 to B-4: 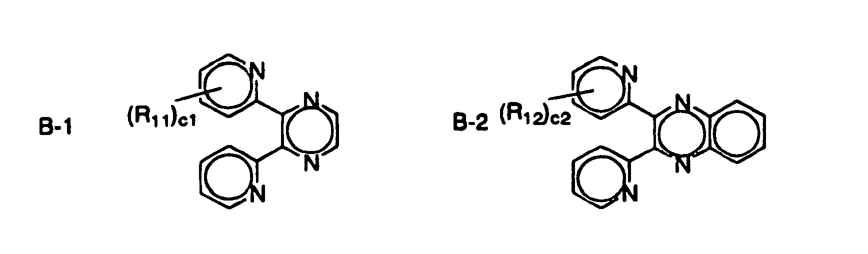 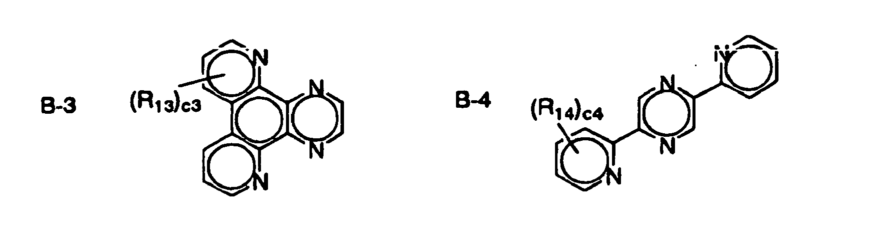 wherein R₁₁ to R₁₄ independently represent a substituent that may be bonded to any carbon atom forming a ring, c1 to c4 independently represent an integer of 0 to 8.
(3) It is preferable that R₁₁ to R₁₄ in the general formulae B-1 to B-4 independently represent an alkyl group, an alkenyl group, an aryl group, a hydroxyl group, an alkoxy group, an amino group, an alkoxycarbonyl group, a carboxyl group, a sulfonic acid group, a phosphoryl group, a phosphonyl group or a halogen atom.
(4) It is preferable that LL₁ and LL₂ independently represent a bidentate or tridentate ligand represented by any one of the following general formulae (IV-1) to (IV-5): 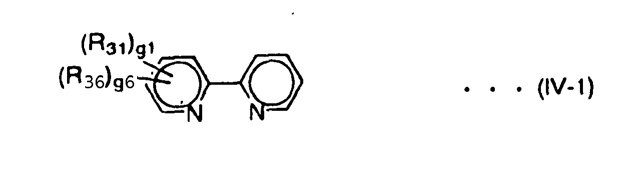 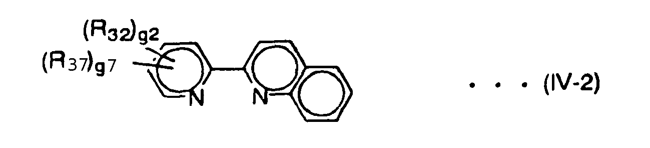 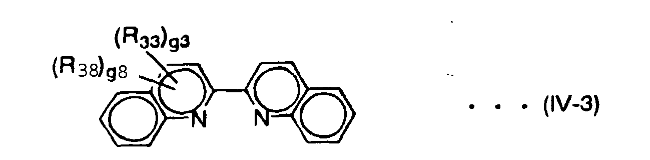 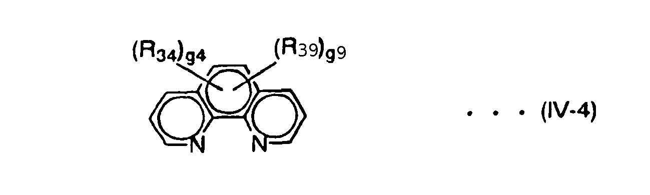 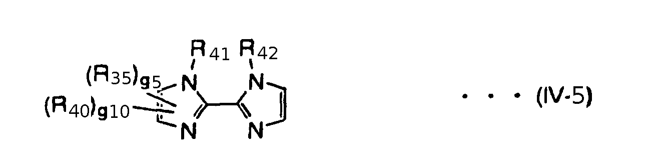 wherein R₃₁ to R₃₅ independently represent a carboxyl group, a sulfonic acid group, a hydroxyl group, a hydroxamic acid group, a phosphoryl group or a phosphonyl group, R₃₆ to R₄₀ independently represent a substituent, R₄₁ to R₄₂ independently represent a hydrogen atom, an alkyl group, an alkenyl group or an aryl group, R₃₁ to R₄₀ may be bonded to any carbon atom forming a ring, g1 to g5, and g10 independently represent an integer of 0 to 4, g6 to g9 independently represent an integer of 0 to 6, R₃₁'s to R₃₅'s may be the same or different groups when g1 to g5 are 2 or more, and R₃₄'s to R₄₀'s may be the same or different groups that may be bonded together to form a ring when g6 to g10 are 2 or more.
(5) It is preferable that R₃₁ to R₃₆ in the general formulae (IV-1) to (IV-5) independently represent a carboxyl group or a phosphonyl group.
(6) It is preferable that R₃₆ to R₄₀ in the general formulae (IV-1) to (IV-5) independently represent an alkyl group, an alkenyl group, a cycloalkyl group, an aryl group, a heterocyclic group, an alkoxy group, an aryloxy group, an acyloxy group, an alkoxycarbonyl group, a carbamoyl group, an acylamino group, an amino group, an acyl group, a sulfonamido group, a cyano group, a hydroxyl group or a halogen atom.
(7) It is preferable that m1 and m3 are 0.
(8) It is preferable that m1 and m3 are 0, and m2 and m4 are 2.
(9) It is preferable that m1 and m3 are 0, and m2 and m4 are 3.
(10) It is preferable that m1 and m3 are 1, and m2 and m4 are 1.
(11) It is preferable that the metal complex dye comprises at least one acidic group.
(12) It is more preferable that the metal complex dye comprises at least one group selected from the group consisting of a carboxyl group, a sulfonic acid group, a hydroxyl group, a hydroxamic acid group, a phosphoryl group and a phsphonyl group.
(13) It is preferable that the semiconductor particles are titanium oxide particles.

As for the metal complex dye according to a particularly preferable embodiment of the present invention, in the general formula (I), M₁ and M₂ independently represent Ru ; BL represents of the general formulae B-1 to B-4; LL₁ and LL₂ independently represent a bidentate ligand represented by the general formulae (IV-1) or (IV-5); X₁ and X₂ independently represent a monodentate or bidentate ligand which coordinates to said metal atom via one or two groups selected from the group consisting of an acyloxy group, an acylthio group, a thioacyloxy group, a thioacylthio group, an acylaminooxy group, a thiocarbamate group, a dithiocarbamate group, a thiocarbonate group, a dithiocarbonate group, a trithiocarbonate group, an acyl group, a thiocyanate group, an isothiocyanate group, a cyanate group, an isocyanate group, a cyano group, an alkylthio group, an arylthio group, an alkoxy group and an aryloxy group, or a monodentate or bidentate ligand selected from the group consisting of halogen atoms, carbonyl, dialkylketones, 1,3-diketones, carbonamides, thiocarbonamides and thioureas; m1 and m3 independently represent 0 or 1; m2 represents an integer of 1 to 4, and X₁'s may be the same or different ligands that may be bonded together when m2 is 2 or more; m4 represents an integer of 1 to 4, and X₂'s may be the same or different ligands that may be bonded together when m4 is 2 or more; and CI represents a counter ion optionally contained to neutralize charge of said metal complex dye.

In this embodiment, it is preferable that X₁ and X₂ independently represent a monodentate or bidentate ligand which coordinates to Ru via one or two groups selected from the group consisting of an acyloxy group, an acylaminooxy group, a dithiocarbamate group, a thiocyanate group, an isothiocyanate group, a cyanate group, an isocyanate group, an alkylthio group and an arylthio group.

### BRIEF DESCRIPTION OF THE DRAWINGS

Fig. 1 is a partial cross sectional view showing a preferable structure of a photoelectric conversion device of the present invention,
Fig. 2 is a partial cross sectional view showing a preferable structure of a photoelectric conversion device of the present invention,
Fig. 3 is a partial cross sectional view showing a preferable structure of a photoelectric conversion device of the present invention,
Fig. 4 is a partial cross sectional view showing a preferable structure of a photoelectric conversion device of the present invention,
Fig. 5 is a partial cross sectional view showing a preferable structure of a photoelectric conversion device of the present invention,
Fig. 6 is a partial cross sectional view showing a preferable structure of a photoelectric conversion device of the present invention,
Fig. 7 is a partial cross sectional view showing a preferable structure of a photoelectric conversion device of the present invention,
Fig. 8 is a partial cross sectional view showing a preferable structure of a photoelectric conversion device of the present invention,
Fig. 9 is a partial cross sectional view showing a preferable structure of a photoelectric conversion device of the present invention, and
Fig. 10 is a partial cross sectional view showing an example of a structure of a substrate-integrated type solar cell module comprising a metal complex dye of the present invention.

### DETAILED DESCRIPTION OF THE PREFERRED EMBODIMENTS

### [1] Metal complex dye

A metal complex dye for use in a photoelectric conversion device of the present invention is represented by the following general formula (I).

(LL₁)ₘ₁(X₁)ₘ₂M₁(BL)M₂(LL₂)ₘ₃(X₂)ₘ₄ · Cl (I)

Constitutional components of the dye will be described in detail below. (A) Metal atom M₁ and M₂

M₁ and M₂ independently represent a metal atom, wherein M₁ and M₂ are Ru, (B) Ligand BL

In the general formula (I), BL represents a ligand having two or more moieties for bidentate or tridentate coordination to the metal atoms. BL preferably has two moieties for bidentate or tridentate coordination. When BL has three or more moieties for coordination, the metal complex dye represented by the general formula (I) may comprises metal atom(s) other than M₁ and M₂, and ligand(s) coordinating thereto. BL preferably coordinates to the metal atoms via atoms selected from the group consisting of a nitrogen atom, a carbon atom, an oxygen atom and a sulfur atom. Among them, a nitrogen atom and carbon atom are more preferred, and a nitrogen atom is particularly preferred.

BL is represented by any one of the following general formulae B-1 to B-4.

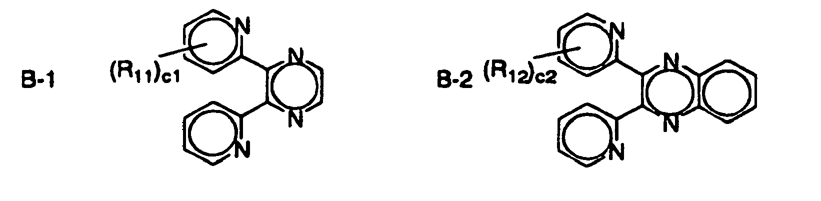

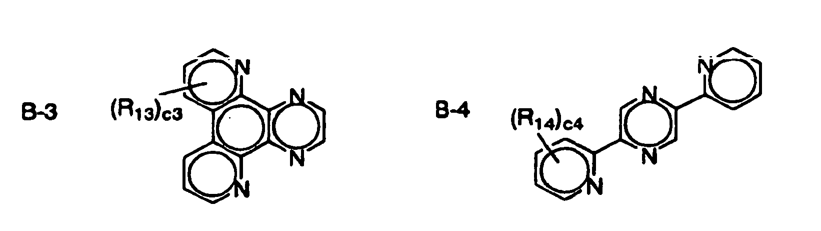

In the general formulae B-1 to B-4, R₁₁ to R₁₄ independently represent a substituent that may be bonded to any carbon atom forming a ring. It is preferable that R₁₁ to R₁₄ independently represent an alkyl group, an alkenyl group, an aryl group, a hydroxyl group, an alkoxy group, an amino group, an alkoxycarbonyl group, a carboxyl group, a sulfonic acid group, a phosphoryl group, a phosphonyl group or a halogen atom. Among them, more preferred are an alkyl group, an alkenyl group, a hydroxyl group, an alkoxy group, a carboxyl group, a sulfonic acid group, a phosphoryl group and a phosphonyl group.

In the general formulae B-1 to B-4, c1 to c4 independently represent an integer of 0 to 8. c1 to c14 are preferably represent an integer of 0 to 2, respectively.

When BL contains an alkyl group, an alkenyl group, etc., they may be a substituted or unsubstituted group having a straight or branched structure. When BL contains an aryl group, a heterocyclic group, etc., they may be a substituted or unsubstituted group having a monocyclic or condensed ring structure.

Specific examples BL-1 to BL-99 of the ligand BL will be illustrated below without intention of restricting the scope of the present invention defined by the claims attached hereto. 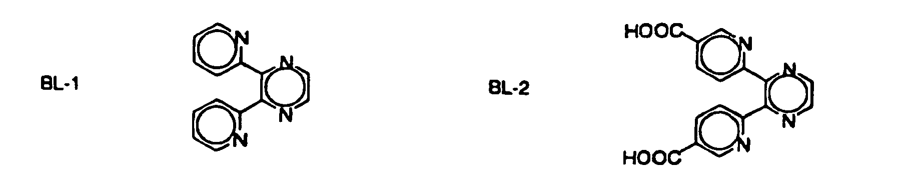 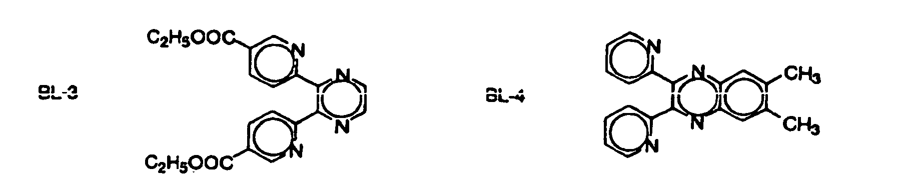 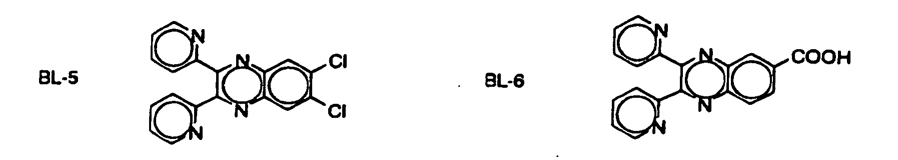 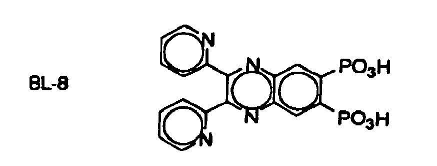 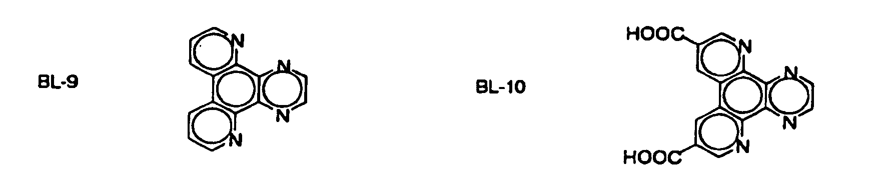 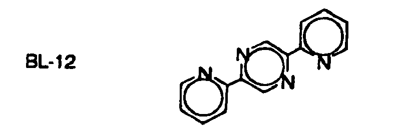 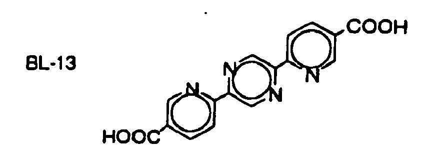 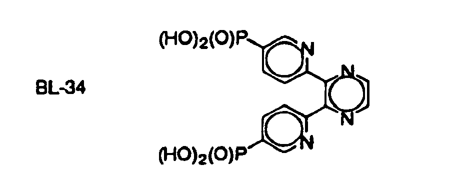 (C) Ligand LL₁ and LL₂

In the general formula (I), LL₁ and LL₂ independently represent a bidentate ligand represented by the following general formula (II). 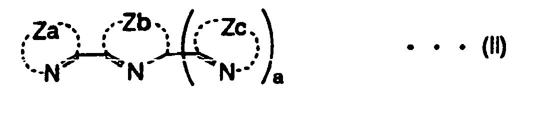 LL₁ and LL₂ may be the same or different ligands, are preferably the same ligands. m1 and m3 each indicating the number of LL₁ and LL₂ are independently 0 or 1.

In the general formula (II), Za, Zb and Zc independently represent nonmetallic atoms forming a 5- or 6-membered ring. The 5- or 6-membered ring may be substituted or unsubstituted ring that may be a monocyclic or a condensed ring. Za, Zb and Zc are preferably composed of carbon, hydrogen, nitrogen, oxygen, sulfur, phosphorus and/or halogen atoms, respectively. They preferably form an aromatic ring. As for the aromatic ring, such rings as an imidazole ring, a triazole ring, a thiazole ring, an oxazole ring, a pyrazole ring, a benzimidazole ring, a benzotriazole ring, a benzoxazole ring and a benzothiazole ring are preferred as a 5-membered ring, and such rings as a pyridine ring, a pyrimidine ring, a pyridazine ring and a pyrazine ring are preferred as a 6-membered ring. Of these rings, more preferred are a benzimidazole ring, an imidazole ring and a pyridine ring, and particularly preferred are an imidazole ring and a pyridine ring. *a* in the general formula (II) is 0.

It is preferable that LL₁ and LL₂ independently represent a bidentate ligand represented by any one of the following general formulae (IV-1) to (IV-5).

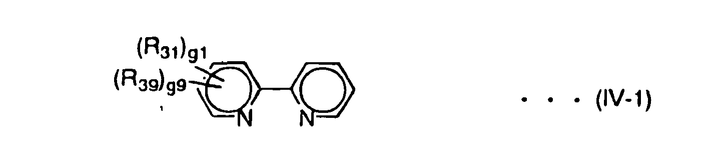

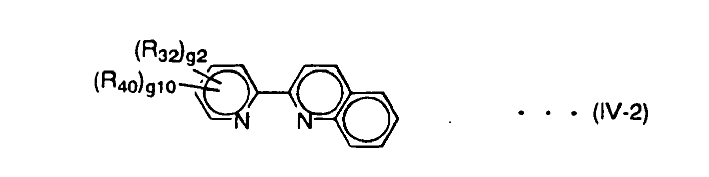

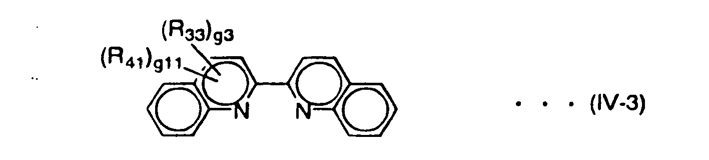

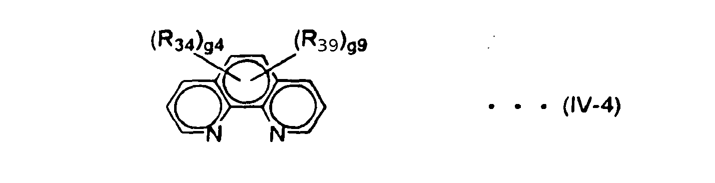

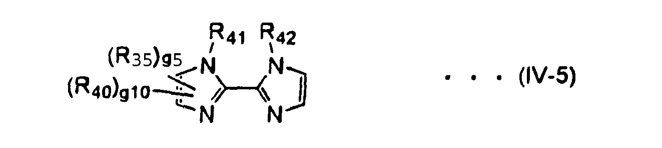

In the general formulae (IV-1) to (IV-5), R₃₁ to R₃₅ independently represent a carboxyl group, a sulfonic acid group, a hydroxyl group, a hydroxamic acid group preferably having 1 to 20 carbon atoms such as - CONHOH, -CONCH₃OH, a phosphoryl group such as -OP(O)(OH)₂, etc. or a phosphonyl group such as -P(O)(OH)₂. Of these groups, preferred are a carboxyl group, a phosphonyl group and a phosphoryl group, more preferred are a carboxyl group and a phosphonyl group, and the most preferred is a carboxyl group.

In the general formulae (IV-1) to (IV-5), R₃₆ to R₄₀ independently represent a substituent. It is preferable that R₃₆ to R₄₀ are independently an alkyl group, an alkenyl group, a cycloalkyl group, an aryl group, a heterocyclic group, an alkoxy group, an aryloxy group, an acyloxy group, an alkoxycarbonyl group, a carbamoyl group, an acylamino group, an amino group, an acyl group, a sulfonamido group, a cyano group, a hydroxyl group or a halogen atom. Preferable examples of these groups are equal to those of R₂₂. R₃₆ to R₄₀ are more preferably an alkyl group, an alkenyl group, an aryl group, a heterocyclic group, an alkoxy group, an alkoxycarbonyl group, an amino group or a halogen atom, particularly preferably an alkyl group, an alkenyl group, an alkoxy group, an alkoxycarbonyl group or an amino group, respectively.

When LL₁ and LL₂ contain an alkyl group, an alkenyl group, they may be a substituted or unsubstituted group having a straight or branched structure. When LL₁ and LL₂ contain an aryl group, a heterocyclic group, they may be a substituted or unsubstituted group having a monocyclic or condensed ring structure.

In the general formulae (IV-1) to (IV-5), R₄₁ to R₄₂ independently represent a hydrogen atom, an alkyl group, an alkenyl group or an aryl group. Preferable examples of these groups are equal to those of R₂₂.

R₄₁ to R₄₂ are preferably a branched alkyl group or an alkyl group having a carboxyl group, independently.

In the general formulae (IV-1) to (IV-5), g1 to g5, and g10 independently represent an integer of 0 to 4, and g6 to g9 independently represent an integer of 0 to 6. g1 to g10 are preferably an integer of 0 to 2, respectively.

R₃₁ to R₄₀ may be bonded to any carbon atom forming a ring. R₃₁'s to R₃₅'s may be the same or different groups when g1 to g6 are 2 or more, and R₃₉'s to R₄₆'s may be the same or different groups that may be bonded together to form a ring when g9 to g16 are 2 or more. It is particularly preferable that R₃₉'s, R₄₀'s, and R₄₁'s are independently an alkyl group or an alkenyl group, and they are bonded together to form a ring when g9, g10 and g11 are 2 or more.

LL₁ and LL₂ is most preferably represented by any one of the general formula (IV-1) or (IV-2).

Specific examples L-1 to L-89 of the ligand LL₁ and LL₂ will be illustrated below.

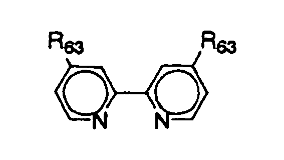

| | R₆₃ |
|---|---|
| L-1 | H |
| L-2 | -CH₃ |
| L-3 | -OC₂H₅ |
| L-4 | -N(C₄H₉)₂ |
| L-5 | -COOH |
| L-6 | -PO₃H₂ |
| L-7 | -CONHOH |
| L-8 | -COOC₂H₅ |
| L-9 | Br |
| L-10 | -OH |
| L-11 | -OPO₃H₂ |
| L-12 | 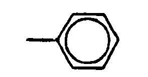 |
| L-13 | -OCOCH₃ |
| L-14 | -SO₃H |

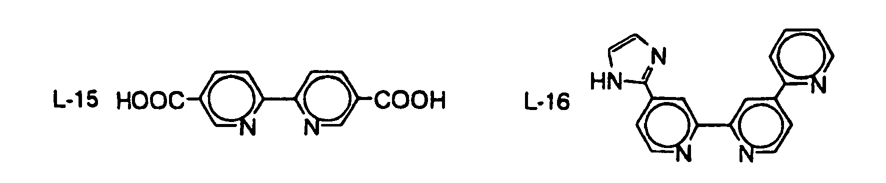

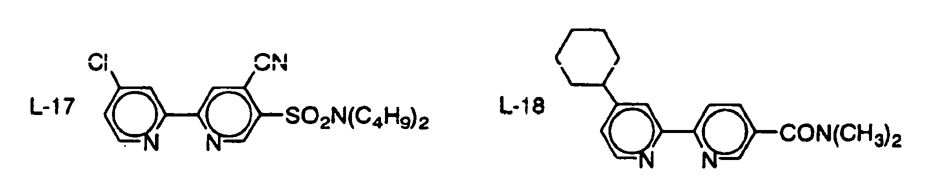

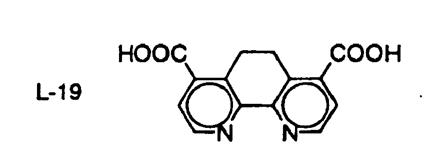

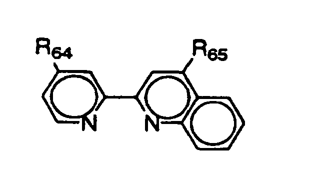

| | R₆₄ | R₆₅ |
|---|---|---|
| L-20 | H | -CH₃ |
| L-21 | H | -COOH |
| L-22 | -COOH | -COOH |
| L-23 | H | -PO₃H₂ |

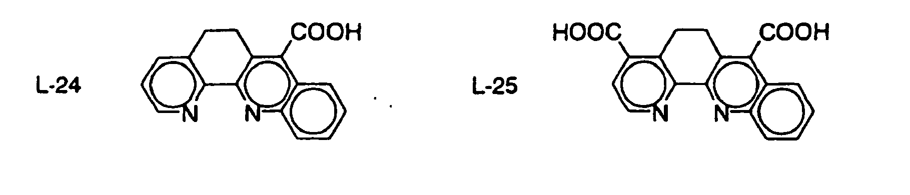

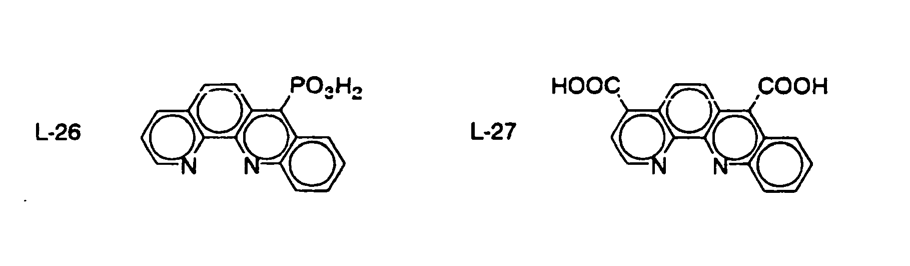

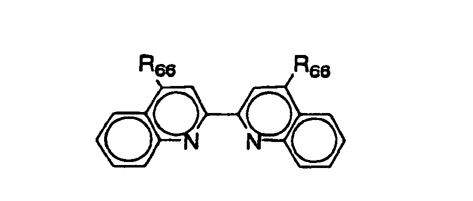

| | R₆₆ |
|---|---|
| L-28 | H |
| L-29 | -COOH |
| L-30 | -OH |
| L-31 | -SO₃H |
| L-32 | -PO₃H₂ |
| L-33 | -OPO₃H₂ |

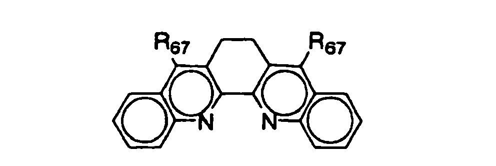

| | R₆₇ |
|---|---|
| L-34 | H |
| L-35 | -CH₃ |
| L-36 | -COOH |

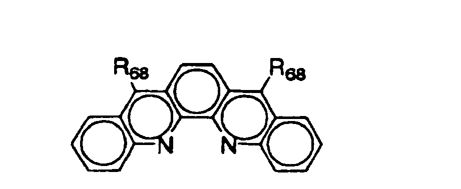

| | R₆₈ |
|---|---|
| L-37 | H |
| L-38 | -CH₃ |
| L-39 | -COOH |
| L-40 | -PO₃H₂ |

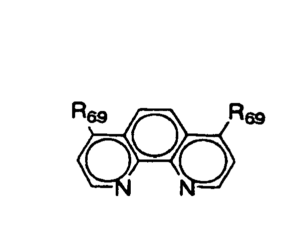

| | R₆₉ |
|---|---|
| L-41 | H |
| L-42 | -CH₃ |
| L-43 | -COOH |

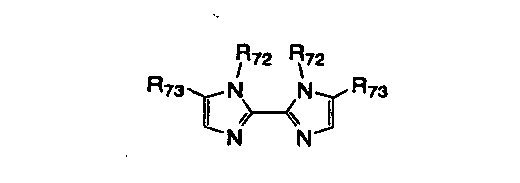

| | R₇₂ | R₇₃ |
|---|---|---|
| L-47 | H | H |
| L-48 | -CH₃ | H |
| L-49 | -CH₂COOH | H |
| L-50 | H | -COOH |
| L-51 | -(CH₂)₂PO₃H₂ | H |

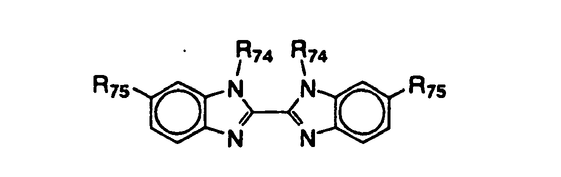

| | R₇₄ | R₇₅ |
|---|---|---|
| L-52 | H | H |
| L-53 | -CH₃ | H |
| L-54 | -C₄H₉ | -COOH |
| L-55 | -CH₂COOH | H |
| L-56 | -CH₂PO₃H₂ | H |

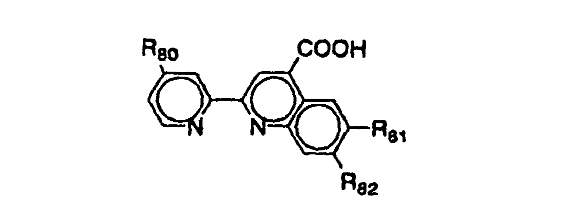

| | R₈₀ | R₈₁ | R₈₂ |
|---|---|---|---|
| L-71 | H | -OCH₃ | H |
| L-72 | H | -OCH₃ | -OCH₃ |
| L-73 | H | -N(C₂H₅)₂ | H |
| L-74 | -COOH | -N(C₂H₅)₂ | H |
| L-75 | -COOH | -OCH₃ | -OCH₃ |
| L-76 | -OCH₃ | -OCH₃ | H |

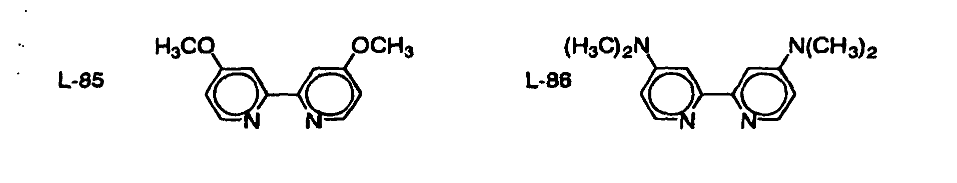

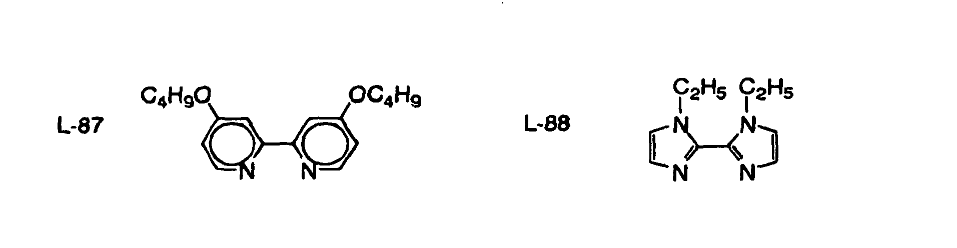

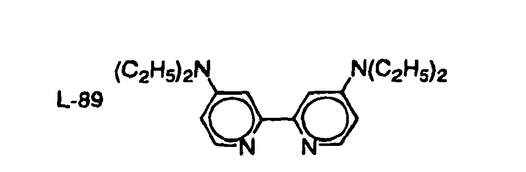

### (D) Ligand X₁ and X₂

In the general formula (I), X₁ and X₂ independently represent a monodentate or bidentate ligand. X₁ and X₂ may be the same or different ligands, are preferably the same ligands. m2 and m4 each indicating the number of X₁ and X₂ independently represents an integer of 0 to 4. X₁'s may be the same or different ligands that may be bonded together when m2 is 2 or more, and X₂'s may be the same or different ligands that may be bonded together when m4 is 2 or more.

X₁ and X₂ independently represent a monodentate or bidentate ligand which coordinates to a metal atom via one or two groups selected from the group consisting of an acyloxy group preferably having 1 to 20 carbon atoms such as an acetyloxy group, a benzoyloxy group, a salicyloyloxy group, a glycyloxy group, an N,N-dimethylglycyloxy group, a oxalylene group (-OC(O)C(O)O-), etc., an acylthio group preferably having 1 to 20 carbon atoms such as an acetylthio group, a benzoylthio group, etc., a thioacyloxy group preferably having 1 to 20 carbon atoms such as a thioacetyloxy group (CH₃C(S)O-), a thiobenzoyloxy group, etc., a thioacylthio group preferably having 1 to 20 carbon atoms such as a thioacetylthio group (CH₃C(S)S-), a thiobezoylthio group (PhC(S)S-), etc., an acylaminooxy group preferably having 1 to 20 carbon atoms such as an N-methylbenzoylaminooxy group (PhC(O)N(CH₃)O-), an acetylaminooxy group (CH₃C(O)NHO-), a *p*-toluoylaminooxy group, etc., a thiocarbamate group preferably having 1 to 20 carbon atoms such as an N,N-diethylthiocarbamate group, an N,N-dimethylthiocarbamate group, etc., a dithiocarbamate group preferably having 1 to 20 carbon atoms such as an N-phenyldithiocarbamate group, an N,N-dimethyldithiocarbamate group, an N,N-diethyldithiocarbamate group, an N,N-dibenzyldithiocarbamate group, etc., a thiocarbonate group preferably having 1 to 20 carbon atoms such as an ethylthiocarbonate group, an methylthiocarbonate group, etc., a dithiocarbonate group preferably having 1 to 20 such as an ethyldithiocarbonate group (C₂H₅OC(S)S-), etc., a trithiocarbonate group preferably having 1 to 20 carbon atoms such as an ethyltrithiocarbonate group (C₂H₅SC(S)S-), etc., an acyl group preferably having 1 to 20 carbon atoms such as an acetyl group, a benzoyl group, etc., a thiocyanate group, an isothiocyanate group, a cyanate group, an isocyanate group, a cyano group, an alkylthio group preferably having 1 to 20 carbon atoms such as a methylthio group, an ethylenedithio group, a propylenedithio group, etc., an arylthio group preferably having 6 to 20 carbon atoms such as a benzenethio group, a 1,2-phenylenedithio group, etc., an alkoxy group preferably having 1 to 20 carbon atoms such as a methoxy group, etc., and an aryloxy group preferably having 6 to 20 carbon atoms such as a phenoxy group, a 1,2-phenylenedioxy group, etc., or a monodentate or bidentate ligand selected from the group consisting of halogen atoms such as a chlorine atom, a bromine atom, an iodine atom, etc., carbonyl (···CO), dialkylketones preferably having 3 to 20 carbon atoms such as acetone ((CH₃)₂CO···), etc., 1,3-diketones preferably having 3 to 20 carbon atoms such as acetylacetone (CH₃C(O-)=CH-C(O···)CH₃), trifluoroacetylacetone (CF₃C(O-)=CH-C(O···)CH₃), dipivaloylmethane (t-C₄H₉C(O-)=CH-C(O ···)-t-C₄H₉), dibenzoylmethane (PhC(O-)=CH-C(O···)Ph), 3-chloroacetylacetone (CH₃C(O-)=CCl-C(O···)CH₃), etc., carbonamides preferably having 1 to 20 carbon atoms such as CH₃N=C(CH₃)O-, - OC(=NH)-C(=NH)O-, ···OC(NH₂)-C(NH₂)O···, etc., thiocarbonamides preferably having 1 to 20 carbon atoms such as CH₃N=C(CH₃)S-, etc., and thioureas preferably having 1 to 20 atoms such as ···NH=C(NH₂)S-, ··· N(CH₃)=C(NHCH₃)S-, (CH₃)₂N-C(S···)N(CH₃)₂, etc. Incidentally, ··· indicates a coordinate bond.

X₁ and X₂ are more preferably a ligand which coordinates to a metal atom via one or two groups selected from the group consisting of an acyloxy group, a thioacylthio group, an acylaminooxy group, a dithiocarbamate group, a dithiocarbonate group, a trithiocarbonate group, a thiocyanate group, an isothiocyanate group, a cyanate group, an isocyanate group, a cyano group, an alkylthio group, an arylthio group, an alkoxy group and an aryloxy group, or a ligand selected from the group consisting of halogen atoms, carbonyl, 1,3-diketones and thioureas, respectively.

X₁ and X₂ are furthermore preferably a ligand which coordinates to a metal atom via one or two groups selected from the group consisting of an acyloxy group, an acylaminooxy group, a dithiocarbamate group, a thiocyanate group, an isoihiocyanaie groups, a cyanate groups, an isocyanate group, a cyano group and an arylthio group, or a ligand selected from the group consisting of halogen atoms, 1,3-diketones and thioureas, respectively. They are particularly preferably a ligand that coordinates to a metal atom via one or two groups selected from the group consisting of a dithiocarbamate group, a thiocyanate group, an isothiocyanate group, a cyanate group and an isocyanate group, or a ligand selected from the group consisting of halogen atoms and 1,3-diketones, respectively. Further, they are most preferably a ligand that coordinates to a metal atom via one or two groups selected from the group consisting of a dithiocarbamate group, a thiocyanate group and an isothiocyanate group, or 1,3-diketone, respectively.

When X₁ and X₂ contain an alkyl group, an alkenyl group, an alkynyl group, an alkylene group, etc., they may be a substituted or unsubstituted group having a straight or branched structure. When X₁ and X₂ contain an aryl group, a heterocyclic group, a cycloalkyl group, etc., they may be a substituted or unsubstituted group having a monocyclic or condensed ring structure.

In the case where X₁ and X₂ are a bidentate ligand, preferred is a ligand which coordinates to a metal atom via one or two groups selected from the group consisting of an acyloxy group, an acylthio group, a thioacyloxy group, a thioacylthio group, an acylaminooxy group, a thiocarbamate group, a dithiocarbamate group, a thiocarbonate group, a dithiocarbonate group, a trithiocarbonate group, an acyl group, an alkylthio group, an arylthio group, an alkoxy group and an aryloxy group, or a ligand selected from the group consisting of 1,3-diketones, carbonamides, thiocarbonamides and thioureas.

In the case where X₁ and X₂ are a monodentate ligand, preferred is a ligand which coordinates to a metal atom via one or two groups selected from the group consisting of an acyloxy group, an acylthio group, an acylaminooxy group, a dithiocarbamate group, an acyl group, a thiocyanate group, an isothiocyanate group, a cyanate group, an isocyanate group, a cyano group, an alkylthio group, an arylthio group, an alkoxy group and an aryloxy group, or a ligand selected from a member consisting of halogen atoms, carbonyl, dialkylketones, 1,3-diketones, carbonamides and thioureas.

In the case where M₁ or M₂ is a metal atom that is tend to form a four-coordinated complex such as Cu, Ni, Pd, Pt, etc., it is preferable that m1 or m3 is 0, and m2 or m4 is 1. In this case, X₁ or X₂ is preferably a monodentate ligand. In the case where M₁ or M₂ is a metal atom that is tend to form a six-coordinated complex, it is preferable that m1 or m3 is 1, m2 or m4 is 1, and X₁ or X₂ is a monodentate ligand. In this case, it is also preferable that m1 or m3 is 0, and m2 or m4 is 2 or 3.

Specific examples X-1 to X-92 of the ligand X₁ and X₂ will be illustrated below. Incidentally, chemical formulae shown below are just a limiting structure of possible resonance structures, and distinction between a covalent bond represented by - and a coordinating bond represented by ··· is also just formal and therefore these bonds do not mean an absolute distinction.

| | | | |
|---|---|---|---|
| X-1 | 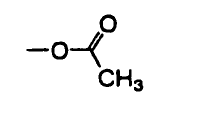 | X-2 | 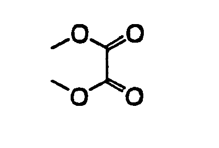 |
| X-3 | 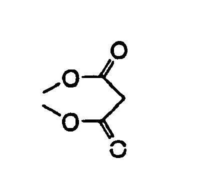 | X-4 | 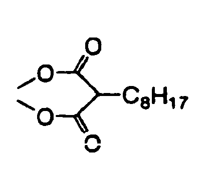 |
| X-5 | 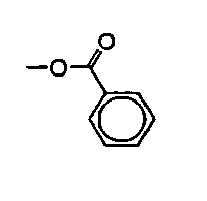 | X-6 | 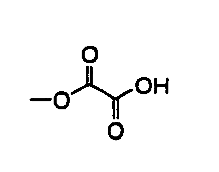 |
| X-7 | 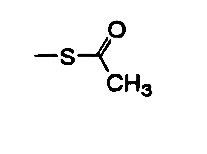 | X-8 | 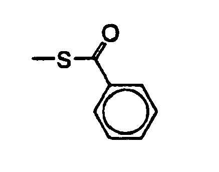 |
| X-9 | 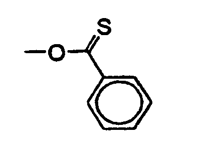 | X-10 | 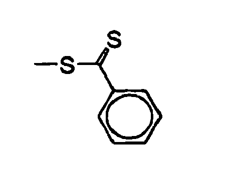 |
| X-11 | 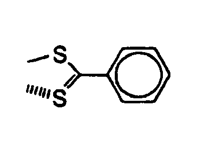 | X-12 | 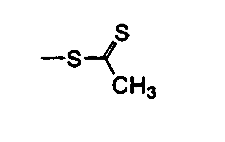 |
| X-13 | 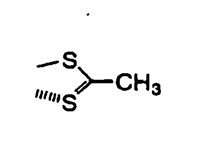 | X-14 | 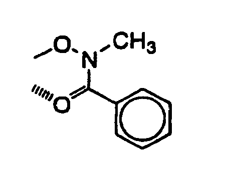 |
| X-15 | 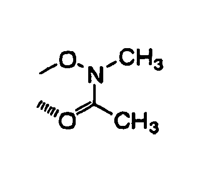 | X-16 | 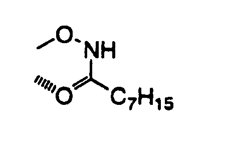 |
| X-17 | 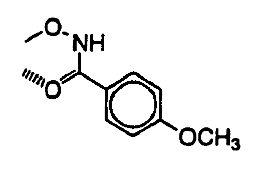 | X-18 | 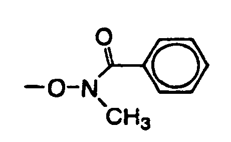 |
| X-19 | 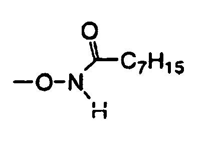 | X-20 | 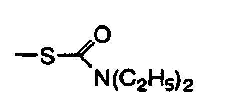 |
| X-21 | 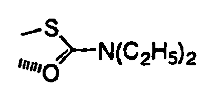 | X-22 | 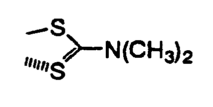 |
| X-23 | 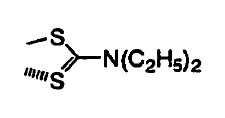 | X-24 | 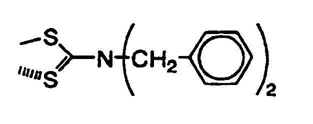 |
| X-25 | 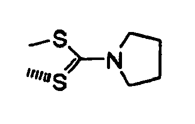 | X-26 | 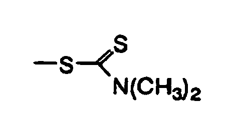 |
| X-27 | 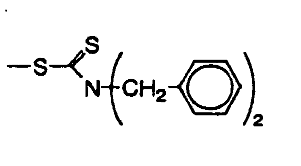 | X-28 | 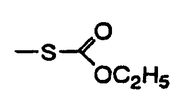 |
| X-29 | 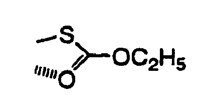 | X-30 | 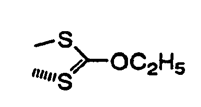 |
| X-31 | 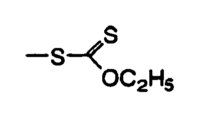 | X-32 | 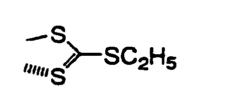 |
| X-33 | 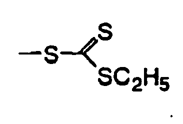 | X-34 | 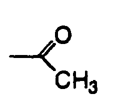 |
| X-35 | 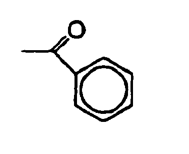 | X-36 | """CO |
| X-37 | 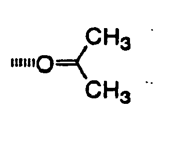 | X-38 | 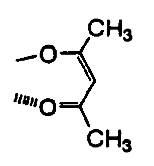 |
| X-39 | 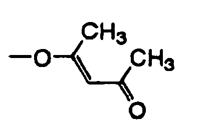 | X-40 | 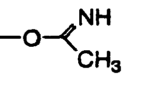 |
| X-41 | 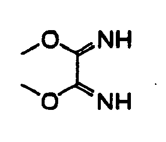 | X-42 | -NCS |
| X-43 | -SCN | X-44 | -NCO |
| X-45 | -OCN | X-46 | -Cl |
| X-47 | -Br | X-48 | -I |
| X-49 | -CN | X-50 | -SCH₃ |
| X-51 | 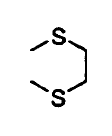 | X-52 | 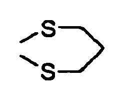 |
| X-53 | 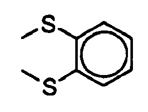 | X-54 | -S(CH₂)₂SH |
| X-55 | -S(CH₂)₃SH | X-56 | 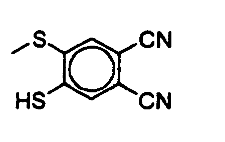 |
| X-57 | -OCH₃ | X-58 | 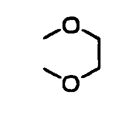 |
| X-59 | 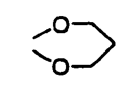 | X-60 | 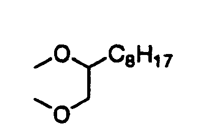 |
| X-61 | 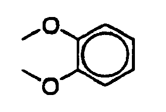 | X-62 | 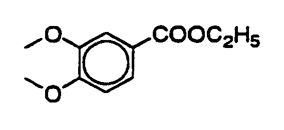 |
| X-63 | 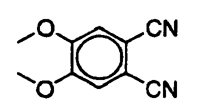 | X-64 | 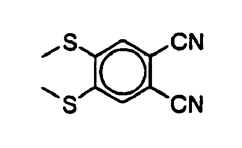 |
| X-65 | 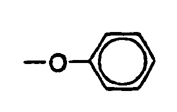 | X-66 | 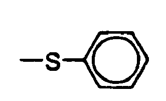 |
| X-67 | 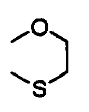 | X-68 | 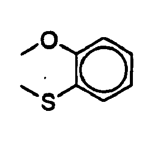 |
| X-69 | -O(CH₂)₂OH | X-70 | -O(CH₂)₃OH |
| X-71 | 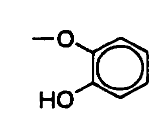 | X-72 | 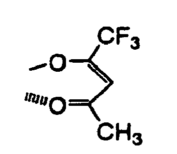 |
| X-73 | 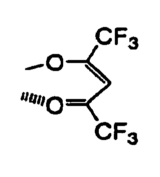 | X-74 | 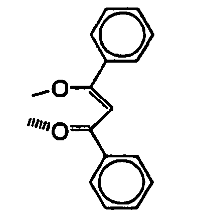 |
| X-75 | 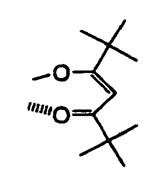 | X-76 | 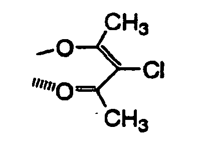 |
| X-77 | 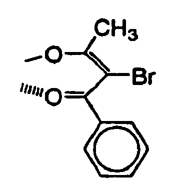 | X-78 | 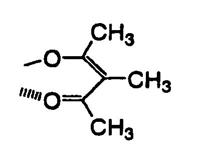 |
| X-79 | 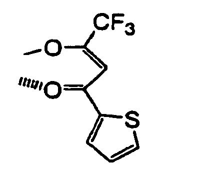 | X-80 | 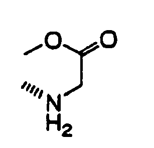 |
| X-81 | 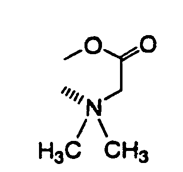 | X-82 | 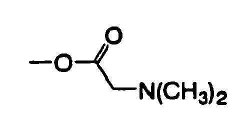 |
| X-83 | 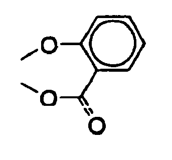 | X-84 | 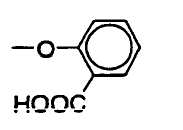 |
| X-85 | 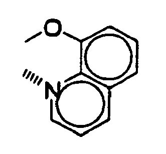 | X-86 | 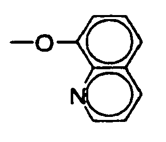 |
| X-87 | 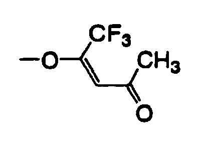 | X-88 | 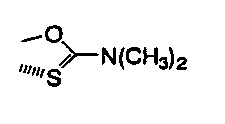 |
| X-89 | 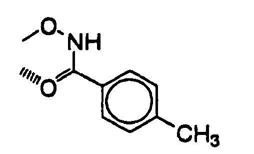 | X-90 | 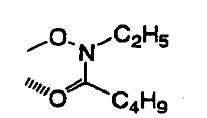 |
| X-91 | 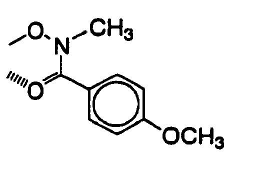 | X-92 | 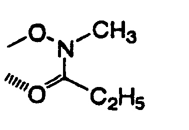 |

### (E) Counter ion CI

CI represents a counter ion optionally contained in the metal complex dye to neutralize charge thereof. Whether the metal complex dye is a cation or an anion and whether the dye has the net ionic charge or not depends on a metal atom, ligands and substituents therein. When a substituent has a dissociative group, it may dissociate the group to have charge. In this case, the charge of the whole complex is also neutralized by CI.

Typical positive counter ions are inorganic or organic ammonium ions such as a tetraalkyl ammonium ion, a pyridinium ion, etc., proton and alkali metal ions. On the other hand, negative counter ions may be inorganic or organic, and examples thereof include a halide ion such as a fuoride ion, a chloride ion, a bromide ion, an iodide ion, etc., a substituted aryl sulfonate ion such as a p-toluene sulfonate ion, a p-chlorobenzene sulfonate ion, etc., an aryl disulfonate ion such as a 1,3-benzene disulfonate ion, a 1,5-naphthalene disulfonate ion, a 2,6-naphthalene disulfonate ion, etc., an alkyl sulfate ion such as a methyl sulfate ion, etc., a sulfate ion, a nitrate ion, a thiocyanate ion, a perchlorate ion, a tetrafluoroborate ion, a hexafluorophosphate ion, a picrate ion, an acetate ion, a trifluoromethane sulfonate ion, etc. Further, ionic polymers or other dyes having an opposite charge to the dye may be also used as a charge-balancing counter ion. Alternatively metal complex such as bisbenzene-1,2-dithiolato nickel (III), etc. can be also used in the present invention.

### (F) Interlocking group

The dye represented by the general formula (I) has preferably at least one, more preferably a plurality of interlocking group suitable for the surface of semiconductor particles. Preferable interlocking groups are acidic groups having a dissociative proton. More preferable interlocking groups include a carboxyl group (-COOH), a sulfonic acid group (-SO₃H), a hydroxyl group (-OH), a phsphonyl group (-P(O)(OH)₂, etc.), a phosphoryl group (-OP(O)(OH)₂, etc.), a hydroxamic acid group (-CONHOH, etc.), etc. π-conductive chelating group such as oxime, dioxime, hydroxyquinoline, salicylate, α-ketoenolate, etc. may also be used as the interlocking group in the present invention. Among them, particularly preferred are a carboxyl group, a phosphoryl group and a phsphonyl group. The interlocking group may form a salt with alkali metal ion, etc., and may form an inner salt.

The interlocking group is preferably contained in BL, LL₁ and/or LL₂, more preferably contained at least in BL.

### (G) Specific examples of the metal complex dye

As for the metal complex dye according to a particularly preferable embodiment of the present invention, in the general formula (I), M₁ and M₂ independently represent Ru ; BL represents a ligand having two or more moieties for bidentate coordination to the metal atoms, represented by any one of the general formulae B-1 to B-10; LL₁ and LL₂ independently represent a bidentate ligand represented by the general formulae (IV-1) or (IV-5); X₁ and X₂ independently represent a monodentate or bidentate ligand which coordinates to said metal atom via one or two groups selected from the group consisting of an acyloxy group, an acylthio group, a thioacyloxy group, a thioacylthio group, an acylaminooxy group, a thiocarbamate group, a dithiocarbamate group, a thiocarbonate group, a dithiocarbonate group, a trithiocarbonate group, an acyl group, a thiocyanate group, an isothiocyanate group, a cyanate group, an isocyanate group, a cyano group, an alkylthio group, an arylthio group, an alkoxy group and an aryloxy group, or a monodentate or bidentate ligand selected from the group consisting of halogen atoms, carbonyl, dialkylketones, 1,3-diketones, carbonamides, thiocarbonamides and thioureas; m1 and m3 independently represent 0 or 1; m2 represents an integer of 1 to 4, and X₁'s may be the same or different ligands that may be bonded together when m2 is 2 or more; m4 represents an integer of 1 to 4, and X₂'s may be the same or different ligands that may be bonded together when m4 is 2 or more; and CI represents a counter ion optionally contained to neutralize charge of said metal complex dye.

In this embodiment, it is preferable that M₁ and M₂ are Ru, BL is represented by any one of the general formulae B-1 to B-4, and X₁ and X₂ independently represent a monodentate or bidentate ligand which coordinates to Ru via one or two groups selected from the group consisting of an acyloxy group, an acylaminooxy group, a dithiocarbamate group, a thiocyanate group, an isothiocyanate group, a cyanate group, an isocyanate group, an alkylthio group and an arylthio group.

Specific examples D-1 to D-301 of the metal complex dye represented by the general formula (I) will be illustrated below. Incidentally, with respect to a ligand marked with' (prime) such as L-5', proton(s) may be dissociated from acidic group(s) such as a carboxyl group in L-5, thereby generating anion(s) such as a carboxylate ion. L-5', etc. may exist in equilibrium with L-5, and a structure of CI may be changed depending on the equilibrium state.

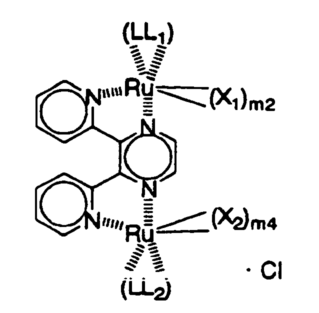

| | LL₁, LL₂ | (X₁)ₘ₂, (X₂)ₘ₄ | Cl |
|---|---|---|---|
| D-1 | L-8 | X-14 | (PF₆)₂ |
| D-2 | L-8 | X-2 | - |
| D-3 | L-8 | X-22 | (PF₆)₂ |
| D-4 | L-8 | (X-42)₂ | - |
| D-5 | L-8 | X-53 | - |
| D-6 | L-8 | X-38 | (PF₆)₂ |
| D-7 | L-5' | X-14 | (HN⁺Et₃)₂ |
| D-8 | L-5' | X-2 | (HN⁺Et₃)₄ |
| D-9 | L-5' | X-22 | (HN⁺Et₃)₂ |
| D-10 | L-5' | (X-42)₂ | (HN⁺Et₃)₄ |
| D-11 | L-5' | X-53 | (HN⁺Et₃)₄ |
| D-12 | L-5' | X-38 | (HN⁺Et₃)₂ |

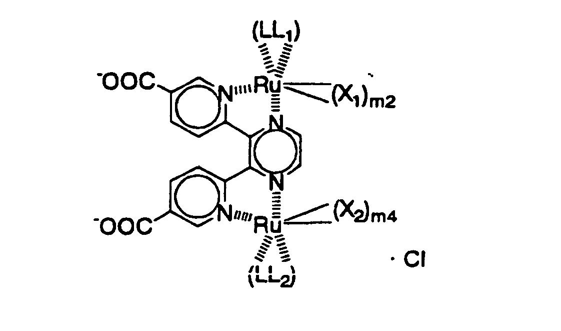

| | LL₁, LL₂ | (X₁)ₘ₂, (X₂)ₘ₄ | Cl |
|---|---|---|---|
| D-13 | L-85 | X-14 | - |
| D-14 | L-85 | X-2 | (HN⁺Et₃)₂ |
| D-15 | L-85 | X-88 | - |
| D-16 | L-85 | (X-42)₂ | (HN⁺Et₃)₂ |
| D-17 | L-85 | (X-44)₂ | (N^{+*n*}Bu₄)₂ |
| D-18 | L-85 | X-38 | - |
| D-19 | L-6 | X-90 | (HN⁺Et₃)₆ |
| D-20 | L-2 | X-52 | (HN⁺Et₃)₂ |

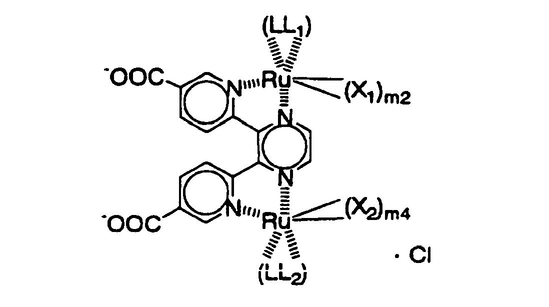

| | LL_{1,} LL₂ | (X₁)ₘ₂, (X₂)ₘ₄ | Cl |
|---|---|---|---|
| D-21 | L-5' | X-91 | (HN⁺Et₃)₄ |
| D-22 | L-5' | X-2 | (HN⁺Et₃)₆ |
| D-23 | L-5' | X-22 | (HN⁺Et₃)₄ |
| D-24 | L-5' | (X-42)₂ | (HN⁺Et₃)₆ |
| D-25 | L-5' | X-38 | (HN+Et₃)₄ |
| D-26 | L-86 | X-14 | - |
| D-27 | L-86 | X-2 | (HN⁺Et₃)₂ |
| D-28 | L-86 | X-23 | - |
| D-29 | L-86 | (X-42)₂ | (HN⁺Et₃)₂ |
| D-30 | L-48 | X-2 | (HN⁺Et₃)₂ |
| D-31 | L-48 | X-24 | |
| D-32 | L-48 | (X-42)₂ | (HN⁺Et₃)₂ |
| D-33 | L-48 | (X-44)₂ | (HN⁺Et₃)₂ |
| D-34 | L-48 | X-38 | - |

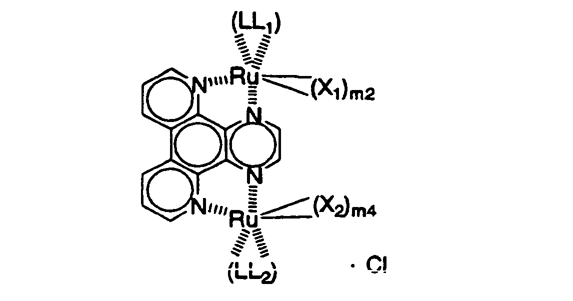

| | LL₁, LL₂ | (X₁)_{m2'} (X₂)ₘ₄ | Cl |
|---|---|---|---|
| D-35 | L-8 | X-2 | - |
| D-36 | L-8 | X-22 | (PF₆)₂ |
| D-37 | L-8 | (X-42)₂ | - |
| D-38 | L-5 | X-14 | (HN⁺Et₃)₂ |
| D-39 | L-5' | X-2 | (HN⁺Et₃)₄ |
| D-40 | L-5' | X-22 | (HN⁺Et₃)₂ |
| D-41 | L-5' | (X-42)₂ | (HN⁺Et₃)₄ |
| D-42 | L-5' | (X-44)₂ | (HN⁺Et₃)₄ |
| D-43 | L-5' | X-53 | (HN⁺Et₃)₄ |
| D-44 | L-5' | X-38 | (HN⁺Et₃)₂ |

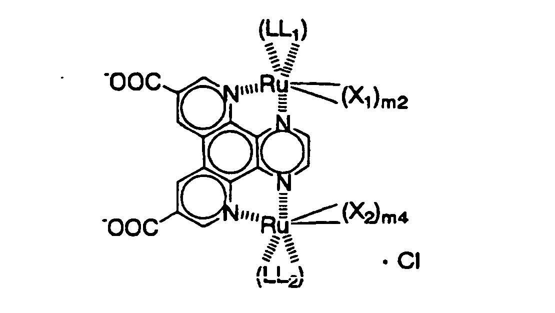

| | LL₁, LL₂ | (X₁)ₘ₂, (X2)ₘ₄ | Cl |
|---|---|---|---|
| D-45 | L-85 | X-14 | - |
| D-46 | L-85 | X-22 | - |
| D-47 | L-85 | (X-42)s | (HN⁺Et₃)₂ |
| D-48 | L-85 | X-38 | - |
| D-49 | L-86 | (X-42)₂ | (HN⁺Et₃)₂ |
| D-50 | L-48 | X-23 | - |
| D-51 | L-48 | (X-42)₂ | (H⁺)₂ |
| D-52 | L-5' | (X-42)₂ | (N+ⁿBu₄)₆ |

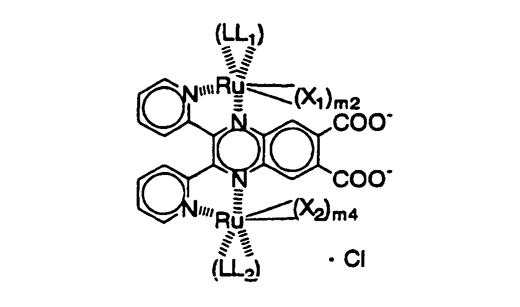

| | LL₁, LL₂ | (X₁)m2, (X₂)ₘ₄ | Cl |
|---|---|---|---|
| D-53 | L-5' | (X-42)₂ | (HN⁺Et₃)₆ |
| D-54 | L-87 | (X-42)₂ | (HN+Et₃)₂ |
| D-55 | L-86 | (X-44)₂ | (HN+Et₃)₂ |
| D-56 | L-88 | (X-42)₂ | (HN+Et₃)₂ |
| D-57 | L-88 | X-14 | - |
| D-58 | L-49' | (X-42)₂ | (N^{+*n*}Bu₄)₆ |

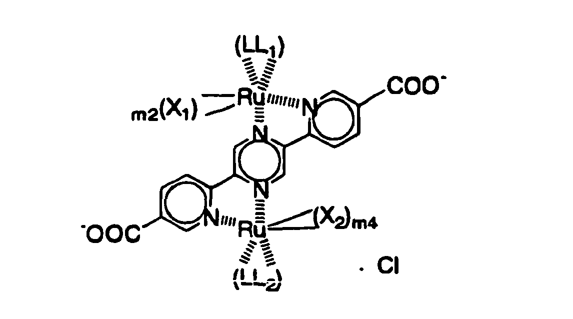

| | LL₁, LL₂ | (X₁)ₘ₂, (X₂)ₘ₄ | Cl |
|---|---|---|---|
| D-59 | L-3 | X-14 | - |
| D-60 | L-3 | X-22 | - |
| D-61 | L-3 | (X-42)₂ | (N^{+*n*}Bu₄)₂ |
| D-62 | L-3 | (X-44)₂ | (N^{+*n*}Bu₄)₂ |
| D-63 | L-3 | X-38 | - |
| D-64 | L-89 | (X-42)₂ | (N^{+*n*}Bu₄)₂ |
| D-65 | L-5' | (X-42)₂ | (HN⁺Et₃)₆ |
| D-66 | L-48 | (X-42)₂ | (HN⁺Et₃)₂ |

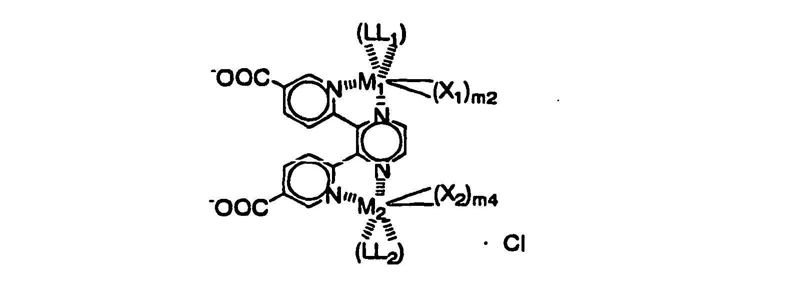

| | M₁ | M₂ | LL₁ | LL₂ | (X₁)ₘ₂ | (X₂)ₘ₄ | Cl |
|---|---|---|---|---|---|---|---|
| D-83 | Ru | Ru | L-1 | L-48 | X-2 | (X-42)₂ | (HN⁺Et₃)₂ |
| D-84 | Ru | Fe | L-85 | L-1 | X-14 | X-2 | HN⁺Et₃ |
| D-85 | Ru | Os | L-2 | L-5 | X-22 | (X-42)₂ | HN⁺Et₃ |
| D-86 | Fe | Fe | L-85 | L-85 | (X-42)₂ | (X-42)₂ | (HN⁺Et₃)₂ |
| D-87 | Os | Os | L-1 | L-1 | X-2 | X-2 | (HN⁺Et₃)₂ |

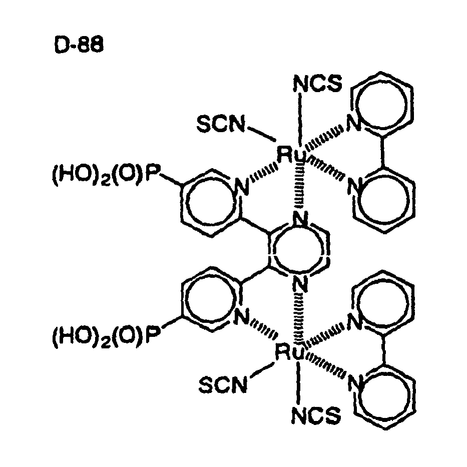

Synthesis of the metal complex dye represented by the general formula (I) according to the present invention can be carried out based on methods described in literatures such as Chem. Eur. J., 1292 (1996), Angew. Chem. Int. Ed. Engl., 34, 1122 (1995), Inorg. Chem. Acta., 154, 77 (1988), Inorg. Chem., 28, 370 (1989), Inorg. Chem., 32, 194 (1993), Angew. Chem. Int. Ed. Engl., 33, 1884 (1994), J. Organometallic. Chem., 453, C19 (1993), Chem. Commun., 869 (1999), Inorg. Chem. Acta., 206, 69 (1993), Inorg. Chem., 29, 1888 (1990), J. Am. Chem. Soc., 109, 2691 (1987), Inorg. Chem., 29, 4750 (1990), Inorg. Chem., 28, 1520 (1989), Inorg. Chem., 29, 167 (1990), and references therein. Incidentally, when the metal complex dye represented by the general formula (I) contains an alkyl group, an alkenyl group, an alkynyl group, an alkylene group, they may be a substituted or unsubstituted group having a straight or branched structure. When the dye contains an aryl group, a heterocyclic , group, a cycloalkyl group, they may be a substituted or unsubstituted group having a monocyclic or condensed ring structure.

### [2] Photoelectric conversion device

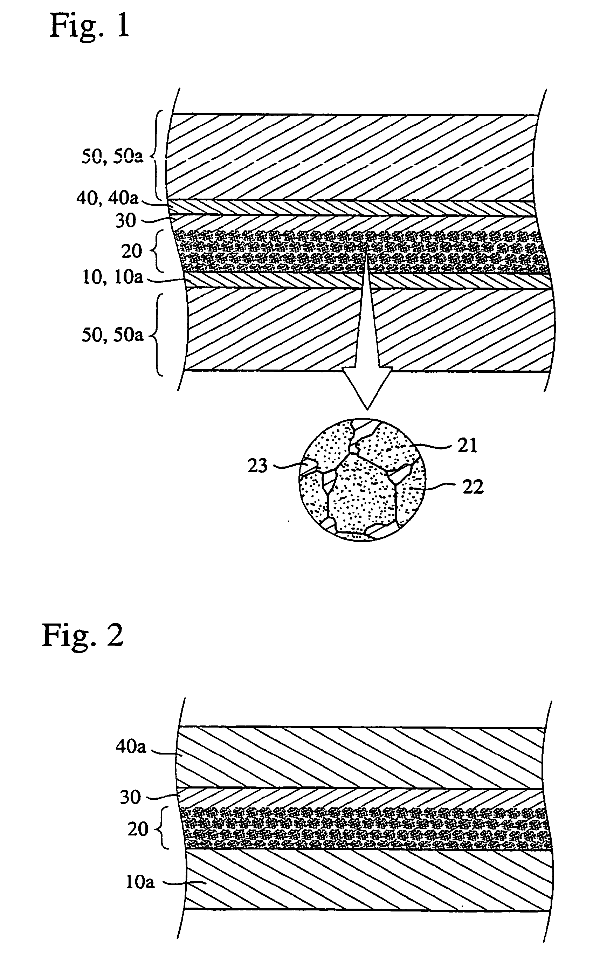

The photoelectric conversion device of the present invention comprises a photosensitive layer containing semiconductor particles sensitized by the above-described metal complex dye. The photoelectric conversion device preferably comprises an electrically conductive layer 10, a photosensitive layer 20, a charge transfer layer 30 and a counter electrically conductive layer 40 each laminated in this order as shown in Fig. 1. The photosensitive layer 20 comprises the semiconductor particles 21 sensitized by a metal complex dye 22 and charge-transporting materials 23 penetrated into voids among the semiconductor particles. The charge-transporting material 23 is composed of the same components as materials for use in the charge transfer layer 30. To improve the strength of the photoelectric conversion device, a substrate 50 may be set on the electrically conductive layer 10 or the counter electrically conductive layer 40. Hereinafter in this specification, a layer composed of the electrically conductive layer 10 and the substrate 50 optionally set thereon is referred to as "conductive support", and a layer composed of the counter electrically conductive layer 40 and the substrate 50 optionally set thereon is referred to as "counter electrode". An article comprising such a photoelectric conversion device connected to an outer circuit is a photoelectric cell. The electrically conductive layer 10, the counter electrically conductive layer 40, and the substrate 50 shown in Fig. 1 may be a transparent electrically conductive layer 10a, a transparent counter electrically conductive layer 40a, and a transparent substrate 50a, respectively.

In the photoelectric conversion device of the present invention shown in Fig. 1, light injected to the photosensitive layer 20 excites the metal complex dye 22, electrons with high energy therein are transferred to a conduction band of the semiconductor particles 21, and they are diffused to reach to the electrically conductive layer 10. At this time, the dye 22, are in the form of the oxidation product. In the photoelectric cell, the electrons in the electrically conductive layer 10 are returned to the oxidation product of the dye 22 etc. through the counter electrically conductive layer 40 and the charge transfer layer 30 while working in the outer circuit, so that the dye 22 is regenerated. The photosensitive layer 20 acts as an anode. In a boundary of each layer such as a boundary between the electrically conductive layer 10 and the photosensitive layer 20, a boundary between the photosensitive layer 20 and the charge transfer layer 30, a boundary between the charge transfer layer 30 and the counter electrically conductive layer 40, components of each layer may be diffused and mixed each other. Each layer is explained in detail below.

### (A) Conductive support

The conductive support is composed of: (1) a single layer of the electrically conductive layer; or (2) two layers of the electrically conductive layer and the substrate. The substrate is not necessary in the case where the electrically conductive layer has sufficient strength and can fully seal the photoelectric conversion device.

In the case (1), the electrically conductive layer is made of a material having a sufficient strength and an electrical conductivity such as a metal, etc.

In the case (2), as the conductive support may be used the substrate having thereon the electrically conductive layer comprising an electrically conductive agent at the photosensitive layer side.

Preferable examples of the electrically conductive agent include metals such as platinum, gold, silver, copper, aluminum, rhodium, indium, etc., carbon and electrically conductive metal oxides such as indium-tin composite oxides, tin oxides doped with fluorine, etc. The thickness of the electrically conductive layer is preferably 0.02 to 10 µm.

It is preferable that the surface resistance of the conductive support is as low as possible. The surface resistance is preferably 100 9/squire or less, more preferably 40 Ω/square or less. The lowest limit of the surface resistance is not limited in particular, generally approximately 0.1 Ω/square.

When a light is irradiated from the side of the conductive support, it is preferred that the conductive support is substantially transparent. The "substantially transparent" conductive support has a light transmittance of 10 % or more in the present invention. The light transmittance is preferably 50 % or more, particularly preferably 70 % or more.

The transparent conductive support preferably composed of the transparent substrate such as a glass substrate, a plastic substrate, etc. and a transparent electrically conductive layer comprising an electrically conductive metal oxide formed by coating or vapor depositing on the surface thereof. Of such supports, an electrically conductive glass in which an electrically conductive layer comprising a tin oxide doped with fluorine is deposited on a transparent substrate made of a low-cost soda-lime float glass is preferred. As for a low-cost and flexible photoelectrical conductive device or solar cell, a transparent polymer film having an electrically conductive layer thereon is preferably used as the transparent conductive support. Examples of materials for the transparent polymer include tetraacetylcellulose (TAC), polyethyleneterephthalate (PET), polyethylenenaphthalate (PEN), syndiotactic polystyrene (SPS), polyphenylenesulfide (PPS), polycarbonate (PC), polyarylate (PAr), polysulfone (PSF), polyestersulfone (PES), polyetherimide (PEI), cyclic polyolefin, brominated phenoxy, etc. To secure a sufficient transparency, it is preferable that the coating amount of the electrically conductive metal oxide is 0.01 to 100 g per 1 m² of a glass or plastic support.

It is preferable to use a metal lead to reduce a resistance of the transparent conductive support. Material of the metal lead is preferably a metal such as aluminum, copper, silver, gold, platinum, nickel, etc., particularly preferably aluminum or silver. It is preferable that the metal lead is applied onto the transparent substrate by vapor deposition, sputtering, or the like, and the transparent electrically conductive layer composed of a tin oxide doped with fluorine or ITO film is applied thereon. It is also preferable that the transparent electrically conductive layer is formed on the transparent substrate, and then the metal lead is applied onto the transparent electrically conductive layer. The reduction in quantity of incident light owing to the metal lead is preferably 10 % or less, more preferably 1 to 5 %.

### (B) Photosensitive layer

In the photosensitive layer containing the semiconductor particles sensitized by the metal complex dye of the present invention, the semiconductor particles act as a so-called photosensitive substance. The semiconductor particles absorb a light to conduct a charge separation, thereby generating electrons and positive holes. In the dye-sensitized semiconductor particles, light-absorption and the generation of electrons and positive holes are primarily caused in the dye, and the semiconductor particles receive and then convey the electrons.

### (1) Semiconductor particles

As the semiconductor particles, simple substances such as silicone and germanium, III-V series compound semiconductors, metal chalcogenides such as oxides, sulfides and selenides, compounds with perovskite structure such as strontium titanate, calcium titanate, sodium titanate, barium titanate and potassium niobate, etc. may be used.

Preferable examples of the metal chalcogenide include oxides of titanium, tin, zinc, iron, tungsten, zirconium, hafnium, strontium, indium, cerium, yttrium, lanthanum, vanadium, niobium or tantalum; sulfides of cadmium, zinc, lead, silver, antimony or bismuth; selenides of cadmium or lead; and cadmium telluride. Examples of other semiconductor compounds include phosphides of zinc, gallium, indium and cadmium; selenides of gallium-arsenic or copper-indium; and copper-indium sulfide, etc.

Preferable specific examples of the semiconductor used in the present invention include Si, TiO₂, SnO₂, Fe₂O₃, WO₃, ZnO, Nb₂O₅, CdS, ZnS, PdS, Bi₂S₃, CdSe, CdTe, GaP, InP, GaAs, CuInS₂, CuInSe₂, etc. Among these semiconductors, more preferred are TiO₂, ZnO, SnO₂, Fe₂O₃ WO₃, Nb₂O₅, CdS, PdS, CdSe, InP, GaAs, CuInS₂ and CuInSe₂, particularly preferred are TiO₂ and Nb₂O₅, and most preferred is TiO₂.

The semiconductor for use in the present invention may be a single crystal or a poly crystal. The single crystal semiconductor is preferred from a viewpoint of a conversion efficiency, while the poly crystal semiconductor is preferred from a viewpoints of a production cost, security of raw materials, a period of energy-payback time, etc.

The particle size of the semiconductor particles is generally in the nm to µm level. The mean size of primary particles, which is obtained from a diameter of a circle equivalent to a projected area, is preferably 5 to 200 nm, more preferably 8 to 100 nm. Further, the mean size of the secondary semiconductor particles in a dispersion is preferably 0.01 to 100 µm.

Two or more kinds of particles having a different particle size distribution from each other, may be mixed to use in the photosensitive layer. In this case, the average particle size of the smaller particles is preferably 5 nm or less. To improve a light-capturing rate by scattering a ray of light, semiconductor particles each having a large particle size, e.g. approximately 300 nm, may be added to the mixture used for composing the semiconductor layer.

Preferred as a method for producing the semiconductor particles are sol-gel methods described in Sumio Sakka, Science of a sol-gel method, Agune Shofusha (1998), Technical information Association, Thin film-coating technology by a sol-gel method (1995), etc. and gel-sol methods described in Tadao Sugimoto, Synthesis of mono-dispersion particles and control of their size and form by a novel gel-sol method, and MATERIA, Vol. 35, No. 9, pp. 1012 to 1018 (1996). Further, the method developed by Degussa Company, which comprises preparing oxides by subjecting chlorides to a high temperature hydrolysis in an oxyhydrogen salt is also preferred.

In the case where titanium oxide is used as the semiconductor particles, any of the above-described sol-gel method, gel-sol method and high temperature hydrolysis method may be preferably used, and further a sulfuric acid method and a chlorine method described in Manabu Seino, Titanium oxide - properties and applied technique, Gihodo Shuppan, (1997) may be used. Also preferred as a sol-gel method are a method described in Christophe J. Barb'e, et al, Journal of American Ceramic Society, Vol. 80, No. 12, pp. 3157 to 3171 (1997) and a method described in Burnside, et al, Chemistry of Materials, Vol. 10, No. 9, pp. 2419 to 2425.

### (2) Semiconductor particle layer

The semiconductor particles may be coated on the conductive support by a method where a dispersion liquid or a colloid solution containing the particles is coated on the electrically conductive layer, the above-mentioned sol-gel method. A wet-type film production method is relatively advantageous for the mass production of the photoelectric conversion device, improvement of properties of semiconductor particles and adaptability of the conductive support. As such a wet-type film production method, a coating method and a printing method are typical examples.

As a method for preparing a dispersion solution containing the semiconductor particles, the sol-gel method mentioned above may be used. Further, the dispersion solution may be prepared by crushing the semiconductor in a mortar, dispersing the semiconductor while grinding in a mill, or precipitating the semiconductor particles in a solvent when the semiconductor is synthesized.

As a dispersion solvent, water or various kinds of organic solvents such as methanol, ethanol, isopropyl alcohol, dichloromethane, acetone, acetonitrile, ethyl acetate, etc. may be used. At the time of dispersion, a polymer, a surfactant, an acid or a chelating agent may be used as a dispersing agent, if necessary.

Preferred coating methods are a roller method and a dip method as an application series, an air-knife method and a blade method as a metering series, etc. Further, preferable as a method where an application and metering can be performed at the same time are a wire-bar method disclosed in JP-B-58-4589, a slide-hopper method described in United States Patent Nos. 2,681,294, 2,761,419, 2,761,791, an extrusion method, a curtain method. Further, as for a wide use, a spin method and a spray method are preferred. As a wet-type printing method, three major printing methods comprising a relief printing, an offset printing and a gravure printing, and an intaglio printing, a gum-printing, a screen printing, etc. are preferred. A preferable film-production method is selected from the above-mentioned methods in accordance with viscosity of the solution and a wet thickness.

The viscosity of the dispersion solution materially depends on the kind and dispersion property of the semiconductor particles, the kind of a solvent and additives such as a surfactant and a binder. For a high viscosity solution (e.g. 0.01 to 500 Poise), an extrusion method, a cast method, a screen-printing method, etc. are preferably used. On the other hand, for a low viscosity solution (e.g. 0.1 Poise or less), a slide-hopper method, a wire-bar method and a spin method are preferably used to form a uniform film. In the case of the low viscosity solution, an extrusion method may be used if the solution is coated to some extent. A wet-type film-production method may be properly selected in accordance with the viscosity of a coating solution, a coating amount, a support, a coating speed and so on.

The layer of the semiconductor particles is not limited to a single layer. The dispersion solutions of semiconductor particles, each of which dispersion has a different particle size may be subjected to a multi-layer coating. Further, alternatively coating solutions each containing different kinds of semiconductor particles (or different kinds of binder, or additives) may be subjected to a multi-layer coating. When a film-thickness is insufficient by coating once, a multi-layer coating is also effective. An extrusion method or a slide-hopper method is suitable for the multi-layer coating. Further, when a multi-layer coating is carried out, multi-layers may be coated at the same time, or alternatively they may be coated one over the other from several times to ten-several times. In the latter case, a screen method is also preferably used.

Generally, in the case where the thickness of the semiconductor particle layer, same as the thickness of a photosensitive layer, becomes thicker, the amount of a dye incorporated therein per unit of the projected area increases, thereby making the light capturing rate higher. However, because a diffusion distance of the generated electrons increases in such a case, a loss owing to recombination of electric charges also increases. Consequently, a preferable thickness of the semiconductor particle layer is 0.1 to 100 µm. When the photoelectric conversion device comprising the semiconductor particle layer is utilized for a photoelectric cell, the thickness of the semiconductor particle layer is preferably 1 to 30 µm, more preferably 2 to 25 µm. A coating amount of the semiconductor particles per 1 m² of the support is preferably 0.5 to 400 g, more preferably 5 to 100 g.

After coating the semiconductor particles on the conductive support, the particles are preferably subjected to a heat treatment to electronically contact them with each other, and to increase a coating strength and an adherence thereof with the support. A heating temperature at the heat treatment is preferably 40°C or more but less than 700°C, more preferably 100 to 600 °C. A heating time is approximately 10 minutes to 10 hours.
It is not preferred that a support having a low melting point or softening point such as a polymer film is subjected to a high temperature treatment because such a support tends to be deteriorated thereby. The heat treatment is preferably carried out at a temperature as low as possible from a viewpoint of the cost. The practice at such a low temperature can be realized by a combination use with the above-described small semiconductor particles having a size of 5 nm or less, a heat treatment in the presence of a mineral acid.

After a heat treatment, a chemical metal-plating using an titanium tetrachloride aqueous solution, etc. or an electrochemical metal-plating using an titanium trichloride aqueous solution may be carried out to increase a surface area of the semiconductor particles, or to enhance a purity in the vicinity of the semiconductor particles, thereby improving an efficiency of electron injection into the semiconductor particles from a dye.

It is preferable that the semiconductor particles have a large surface area, so that they can adsorb lots of dyes.
Therefore, the surface area in the state that the semiconductor particle layer have been coated on the support is preferably 10 times or more, more preferably 100 times or more of the projected area. The highest limit, even though it is not limited in particular, is generally a level of 1000 times.

### (3) Adsorption of metal complex dye onto semiconductor particles

The metal complex dye may be adsorbed onto the semiconductor particles by soaking the conductive support having thereon the well-dried semiconductor particle layer in a solution of the metal complex dye, or by coating a solution of the metal complex dye onto the semiconductor particle layer. In the former case, a soaking method, a dipping method a roller method, an air-knife method, etc. may be used. In the soaking method, the dye may be adsorbed at a room temperature or while refluxing as described in JP-A-7-249790. As a coating method of the latter, a wire-bar method, a slide-hopper method, an extrusion method, a curtain method, a spin method, a spray method, etc. may be used. Further, as a printing method, a relief printing, an offset printing, a gravure printing, a screen-printing, etc. may be used. A solvent therefor may be properly selected in accordance with the solubility of the metal complex dye. Examples of the solvent include alcohols such as methanol, ethanol, t-butanol, benzyl alcohol, nitriles such as acetonitrile, propionitrile, 3-methoxypropionitrile, nitromethane, halogenated hydrocarbons such as dichloromethane, dichloroethane, chloroform, chlorobenzene, ethers such as diethylether, tetrahydrofuran, dimethylsulfoxide, amides such as N,N-dimethylformamide, N,N-dimethylacetamide, N-methylpyrrolidone, 1,3-dimethylimidazolidinone, 3-methyloxazolidinone, esters such as ethylacetate, butylacetate, carbonates such as diethyl carbonate, ethylene carbonate, propylene carbonate, ketones such as acetone, 2-butanone, cyclohexanone, hydrocarbons such as hexane, petroleum ether, benzene, toluene, water, and mixture thereof.

Similar to the case of forming the semiconductor particle layer, various kinds of coating methods can be also selected in accordance with the viscosity of the metal complex dye solution. For a high viscosity solution (e.g. 0.01 to 500 Poise), an extrusion method, and various kinds of printing methods are suitable. On the other hand, for a low viscosity solution (e.g. 0.1 Poise or less), a slide-hopper method, a wire bar method and a spin method are suitable. A uniform film can be made by any of them.

Thus, adsorption method of the dye may be properly selected in accordance with the viscosity of the coating solution of the metal complex dye, the coating amount, the conductive support, the coating speed. It is preferable that the time that is required to adsorb the dye after coating is as short as possible from a viewpoint of mass production.

Because the unadsorbed metal complex dye causes disturbance of efficiency of the device, it is preferable that they are removed by washing immediately after adsorption. The washing is preferably carried out using a wet-type washing bath with a polar solvent such as acetonitrile, or an organic solvent such as an alcohol-based solvent. To enhance the adsorption amount of the dye, it is preferable to carry out a heat treatment before adsorption. After the heat treatment, it is preferable that the dye is quickly adsorbed at 40 to 800 °C without cooling to a room temperature in order to prevent adsorption of water onto the surface of the semiconductor particles.

The total amount of the metal complex dye to be used is preferably 0.01 to 100 mmol per the unit surface area (1 m²) of the conductive support. Further, the amount of the dye to be adsorbed onto semiconductor particles is preferably 0.01 to 1 mmol per g of the semiconductor particles. Such an adsorption amount of the metal complex dye effects a sufficient sensitization to the semiconductors. In contrast, if the amount of the dye is too small, the sensitization effect is not enough. On the other hand, if excessive, the dye unadsorbed onto the semiconductor particles floats, thereby reducing sensitization effect.

With regard to the photoelectric conversion device of the present invention, two or more kinds of dyes may be mixed and used therein to extend the wave range of the photoelectric conversion and to increase a conversion efficiency. In this case, the dyes and their proportion are preferably selected in accordance with the wavelength region and the intensity distribution of a light source. Specifically, two or more kinds of the metal complex dyes of the present invention may be used in combination, or the dye of the present invention and a prior art metal complex dye and/or a polymethine dye may be used in combination.

A colorless compound may be co-adsorbed on the semiconductor particles together with the metal complex dye to weaken an interaction between the metal complex dyes, such as association. Examples of the hydrophobic compounds for the co-adsorption include steroid compounds having a carboxyl group such as chenodeoxycholic acid, etc. Further, an UV-absorbing agent may be used together therewith.

The surface of the semiconductor particles may be treated with amines after adsorbing the metal complex dye to accelerate to remove an excessive metal complex dye. Preferable examples of the amines include pyridine, 4-t-butylpyridine, polyvinylpyridine, etc. The amine may be used as it is when it is liquid, and used as a solution with an organic solvent.

### (C) Charge transfer layer

The charge transfer layer replenishes electrons to the oxidized metal complex dye. Typical examples of materials for use in the charge transfer layer include a an electrolysis solution having a redox coupler dissolved in an organic solvent, a so-called gel electrolyte where a liquid composed of an organic solvent and a redox coupler dissolved therein is penetrated into a polymer matrix, a fused salt containing redox couple, etc. Further, a solid electrolyte and a hole-transporting material may be used for the charge transfer layer.

The electrolysis solution used in the present invention preferably comprises an electrolyte, a solvent and additives. The electrolyte may be: (a) a combination of I₂ and iodides (e.g. metal iodides such as LiI, NaI, CsI, CaI₂, quaternary ammonium iodides such as tetraalkyl ammonium iodide, pyridinium iodide, imidazolium iodide, etc.); (b) a combination of Br₂ and bromides (e.g. metal bromides such as LiBr, NaBr, KBr, CsBr, CaBr₂, quaternary ammonium bromides such as tetraalkyl ammonium bromide, pyridinium bromide, etc.); (c) metal complexes comprising a ferrocyanide-ferricyanide, a ferrocene-ferricinium ion, etc.; (d) sulfur compounds such as sodium polysulfide, alkylthiol-alkyldisulfide, etc.; and (e) viologen dye, hydroquinone-quinone, etc. Among them, a combination of I₂ and iodide such as LiI and quaternary ammonium iodide is preferably used. The above-described electrolytes may be used as a mixture thereof. Further, fused salts described in EP 718288, WO 95/18456, J. Electrochem. Soc., Vol. 143, No. 10, 3099 (1996), Inorg. Chem., 35, 1168 to 1178 (1996), etc. may be used as an electrolyte. When the fused salts are used as an electrolyte, no solvent is necessary to use, generally.

The density of electrolyte in the electrolysis solution is preferably 0.1 to 15 M, more preferably 0.2 to 10 M. When iodine is added to an electrolyte, the iodine density therein is preferably 0.01 to 0.5 M.

It is desirable that used as a solvent for the electrolyte is a compound that exhibits an excellent ionic conductibility. Such a compound exhibits a low viscosity and a high ionic mobility, and/or exhibits a high permittivity and a high actual carrier concentration. The following compounds are given as examples of the above-mentioned solvents.

### (a) Carbonates

Ethylene carbonate, propylene carbonate, vinylene carbonate, butylene carbonate, dimethyl carbonate, diethyl carbonate, methylethyl carbonate, and dipropyl carbonate are preferred examples.

### (b) Lactones

γ-butyrolactone, γ-valerolactone, γ-capryrolactone, crotolactone, γ-caprolactone, and δ-valerolactane are preferred examples.

### (c) Ethers

Ethyl ether, 1,2-dimethoxyethane, diethoxyethane, trimethoxymethane, ethyleneglycol dimethylether, polyethyleneglycol dimethylether, 1,3-dioxolan, and 1,4-dioxan are preferred examples.

### (d) Alcohols

Methanol, ethanol, ethyleneglycol monomethylether, propyleneglycol monoethylether, polyethyleneglycol monoalkylether, and polypropyleneglycol monoalkylether are preferred examples.

### (e) Glycols

Ethyleneglycol, propyleneglycol, polyethyleneglycol, polypropylene glycol, and glycerin are preferred examples.

### (f) Glycol ethers

Ethyleneglycol dialkylether, propyleneglycol dialkylether, polyethyleneglycol dialkylether, and polypropyleneglycol dialkylether are preferred examples.

### (g) Tetrahydrofurans

Tetrahydrofuran, and 2-methyltetrahydrofuran are preferred examples.

### (h) Nitriles

Acetonitrile, glutarodinitrile, propionitrile, methoxyacetonitrile, and benzonitrile are preferred examples.

### (i) Carboxylates

Methyl formate, methyl acetate, ethyl acetate, and methyl propionate are preferred examples.

### (j) Phosphoric acid triesters

Trimethyl phosphate and triethyl phosphate are preferred examples. (k) Heterocyclic compounds

N-methyl pyrrolidone, 4-methyl-1,3-dioxane, 2-methyl-1,3-dioxolan, 3-methyl-2-oxazolidinone, 1,3-propansultone, and sulfolane are preferred examples.

### (1) Others

Aprotic organic solvents such as dimethylsulfoxide, formamide, N,N-dimethylformamide, nitromethane, etc. and water are preferred examples.

Of these compounds, carbonates, nitriles, and heterocyclic compounds are preferred as solvents. Mixed solvent composed of two or more kinds of the solvents may be used if necessary.

In the present invention, a basic compound such as t-butylpyridine, 2-pycoline, 2,6-lutidine, etc. as described in J. Am. Ceram. Soc., 80 (12), 3157 to 3171 (1997) may be added. The concentration of the basic compound is preferably 0.05 to 2 M.

An electrolyte may be gelled (solidified). Gelation may be carried out by: adding a polymer or an oil-gelling agent; polymerization of multifunctional monomers added to the electrolysis solution; or a cross-linking reaction with a polymer. When the electrolyte is gelled by adding the polymer, compounds described in Polymer Electrolyte Reviews-1, 2, (edited by J. R. MacCaLLum and C. A. Vincent, ELSEIVER APPLIED SCIENCE) may be used, and polyacrylonitrile or poly(vinylidene fluoride) is particularly preferably used. When the electrolyte is gelled by adding the oil-gelling agent, compounds described in J. Chem: Soc. Japan, Ind. Chem. Soc., 46, 779 (1943), J. Am. Chem. Soc., 111, 5542 (1989), J. Chem. Soc., Chem. Commun., 1993, 390, Angew. Chem. Int. Ed. Engl., 35, 1949 (1996), Chem. Lett., 1996, 885, J. Chem. Soc., Chem. Commun., 545 (1997),etc. may be used as the oil-gelling agent. Among them, preferred are those having an amide structure.

In the case where a gel electrolyte is formed by polymerization of multifunctional monomers co-existing with the electrolyte, the electrolysis solution comprising the multifunctional monomers, a polymerization initiator, the electrolyte and a solvent is prepared, and coated on the dye-sensitized semiconductor particle layer (photosensitive layer 20) according to a method such as a casting method, a coating method, a soaking method and an impregnation method. In this case, the electrolysis solution is preferably gelled by filling voids among the semiconductor particles 21 with the solution in a sol state to form a sol electrolyte layer on the photosensitive layer 20 as shown in Fig. 1, followed by a radical polymerization.

It is preferable that the multifunctional monomer has two or more ethylenycally unsaturated groups. Preferable examples thereof include divinyl benzene, ethyleneglycol diacrylate, ethyleneglycol dimethacrylate, diethyleneglycol diacrylate, diethyleneglycol dimethacrylate, triethyleneglycol diacrylate, triethyleneglycol dimethacrylate, pentaerythritol triacrylate and trimethylolpropane triacrylate.

The gel electrolyte may contain unifunctional monomers together with the above-described multifunctional monomers. Preferable examples of the unifunctional monomers include esters or amides derived from an acrylic acid or an α-alkylacrylic acid such as methacrylic acid (e.g. N-isopropyl acrylamide, acrylamide, 2-acrylamido-2-methylpropane sulfonic acid, acrylamidopropyl trimethylammonium chloride, methyl acrylate, hydroxyethyl acrylate, N-propylacrylate, N-butylacrylate, 2-methoxyethylacrylate, cyclohexylacrylate), vinyl esters (e.g. vinyl acetate), maleate or fumarate (e.g. dimethyl maleate, dibutyl maleate, diethyl fumarate) , organic acid salts (e.g. sodium salts of maleic acid, fumaric acid or p-styrene sulfonic acid), nitriles (e.g. acrylonitrile, methacryronitrile), dienes (e.g. butadiene, cyclopentadiene, isoprene ,) aromatic vinyl compounds (e.g. styrene, p-chlorostyrene, sodium styrene sulfonate), vinyl compounds having a nitrogen-containing heterocyclic ring, vinyl compounds having a quaternary ammonium salt, N-vinylformamide, N-vinyl-N-methylformamide, vinyl sulfonic acid, sodium vinylsulfonate, vinylidene fluoride, vinylidene chloride, vinyl alkyl ethers (e.g. methyl vinyl ether), olefins (e.g. ethylene, propylene, 1-butene, isobutene), and N-phenyl maleimide.

The weight ratio of the multifunctional monomer to the total of the monomers is preferably 0.5 to 70 weight %, more preferably 1.0 to 50 weight %.

The above-described monomers for a gelation can be polymerized by a general radical polymerization method described in Takayuki Otsu and Masaetsu Kinoshita, Kobunshi Gosei no Jikkenho (Kagaku Dojin), Takayuki Otsu, Koza Jugo Hannoron 1 Rajikaru Jugo (I) (Kagaku Dojin), etc. Radical polymerization of the monomers for a gelation can be carried out by heating, light, an ultraviolet ray or electron ray, or by an electrochemical method. Radical polymerization by heating is particularly preferred.

In the case where a cross-linking polymer is formed by heating, preferable examples of the polymerization initiator include azo initiators such as 2,2'-azobis(isobutyronitrile), 2,2'-azobis(dimethytvaleronitrile) and dimethyl 2,2'-azobis(2-methylpropionate), and peroxide initiators such as benzoyl peroxide, etc. The weight ratio of the initiator is preferably 0.01 to 20 weight %, more preferably 0.1 to 10 weight %, based on the total amount of monomers.

The weight ratio of the monomers accounting for the gel electrolyte is preferably in the range of 0.5 to 70 weight %, more preferably 1.0 to 50 weight %.

In the case where the gelation of the electrolyte is accomplished by a cross-linking reaction of polymers, it is desired to use a polymer having a group with a cross-linking reactivity, in combination with a cross-linking agent. Preferable examples of the group with a cross-linking reactivity include nitrogen-containing groups having heterocyclic structure such as a pyridine ring, an imidazole ring, a thiazole ring, an oxazole ring, a triazole ring, a morpholine ring, a piperidine ring, a piperazine ring, etc. Preferable examples of the cross-linking agent include bi- or multifunctional electrophilic agents to be reacted with the nitrogen such as alkyl halide, aralkyl halide, sulfonate, acid anhydride, isocyanate, etc.).

Organic hole-transporting materials and/or inorganic hole-transporting materials may be used in place of the electrolyte. Preferable examples of the organic hole-transporting material include the following compounds.

### (a) Aromatic amines

N,N'-diphenyl-N,N'-bis(4-methoxyphenyl)-(1,1'-biphenyl)-4,4'-diamine described in J. Hagen et al., Synthetic Metal, 89, 215 to 220 (1997), 2,2',7,7'-tetrakis(N,N'-di-p-methoxyphenylamine)-9,9'-spirobifluorene described in Nature, Vol. 395, 8 Oct. 1998, pp. 583 to 585 and WO 97/10617, aromatic diamine compounds composed of linked tertiary aromatic amine units of 1,1'-bis{4-(di-p-tolylamino)phenyl} cyclohexane described in JP-A-59-194393, aromatic amines having 2 or more of tertiary amino groups in which 2 or more of condensed aromatic rings are bonded to nitrogen atom(s), such as 4,4'-bis[(N-l-naphthyl-N-phenylamino)] biphenyl described in JP-A-5-234681, aromatic triamines derived from triphenyl benzene, having a starburst structure described in United States Patent No. 4,923,774 and JP-A-308688, aromatic diamines such as N,N'-diphenyl-N,N'-bis(3-methylphenyl)-(1,1'-biphenyl)-4,4'-diamine described in United States Patent No. 4,764,625, α,α,α',α'-tetramethyl-α,α'-bisf 4-(di-p-tolylamino)phenyl}-p-xylene described in JP-A-3-269084, p-phenylenediamine derivatives, asymmetric triphenylamine derivatives described in JP-A-4-129271, compounds having a pyrenyl group substituted by a plurality of aromatic diamino groups described in JP-A-4-175395, aromatic diamines where tertiary aromatic amine units are linked via ethylene groups described in JP-A-4-2641 89, aromatic diamines having a styrene moiety described in JP-A-4-290851, benzylphenyl compounds described in JP-A-4.-364153, tertiary amines linked via a fluorene moiety described in JP-A-5-25473, triamine compounds described in JP-A-5-239455, bis(dipyridylamino)biphenyl described in JP-A-5-320634, N,N,N-triphenylamine derivatives described in JP-A-6-1972, aromatic diamines having a phenoxazine structure described in JP-A-7-138562, diaminophenylphenanthridine derivatives described in JP-A-7-252474, etc.

### (b) Oligothiophene compounds

α-octylthiophene and α,ω-dihexyl-α-octylthiophene described in Adv. Mater., Vol. 9, No. 7, 5578 (1997), hexadodecyldodecythiophene described in Angew. Chem. Int. Ed. Engl., 34, No. 3, 303 to 307 (1995), 2,8-dihexylanthra[2,3-b:6,7-b'] dithiophene described in JACS, Vol. 120, No. 4, 664 to 672 (1998), etc.

### (c) Conductive polymers

Polypyrrole (K. Murakoshi et al., Chem. Lett., 1997, p. 471), polyacetylene and derivatives thereof, poly(p-phenylene) and derivatives thereof, poly(p-phenylenevinylene) and derivatives thereof, polythienylenevinylene and derivatives thereof, polythiophene and derivatives thereof, polyaniline and derivatives thereof, and polytoluidine and derivatives thereof described in Handbook of Organic Conductive Molecules and Polymers, Vol. 1 to 4 (edited by NALWA, published by WILEY), etc.

As described in Nature, Vol. 395, 8 Oct. 583 to 585 (1998), to the organic hole-transporting material may be added a compound containing cation radical such as tris(4-bromophenyl)aminium hexachloroantimonate to control a dopant level, and/or a salt such as Li[(CF₃SO₂)₂N] to cany out a potential-control of surface of the oxide semiconductor thereby compensating a space-charge layer.

The organic hole-transporting materials may be introduced into the electrodes by a vacuum deposition method, a casting method, a coating method, a spin-coating method, a soaking method, an electrolytic polymerization method, a photo electrolytic polymerization method, etc. When the hole-transporting material is used in place of the electrolysis solution, it is preferable that a titanium dioxide thin layer is coat as an undercoating layer to be shortproof by a spray pyrolysis described in Electrochim. Acta., 40, 643 to 652 (1995), etc.

In the case of an inorganic solid compound is used in place of the electrolyte, copper iodide (p-Cul) described in J. Phys. D:Appl. Phys., 31, 1492 to 1496 (1998), copper thiocyanide described in Thin Solid Films, 261, 307 to 310 (1995), J. Appl. Phys., 80(8), 15 October 1996, 4749 to 4754, Chem. Mater., 10, 1501 to 1509 (1998) and SemiCond. Sci. Technol., 10, 1689 to 1693, and the like may be introduced into the electrode by a casting method, a coating method, a spin-coating method, a soaking method, an electrolytic metal plating method, etc.

In order to form the charge transfer layer, two methods as described below may be used. One is a method comprising the steps of laminating a counter electrode on the semiconductor particle layer through a spacer, and dipping open-ends of both layers into the electrolysis solution to spread the electrolysis solution into the interior of the semiconductor particle layer and voids between the semiconductor particle layer and the counter electrode. Another is a method comprising the steps of coating the electrolyte solution onto the semiconductor particle layer, thereby spreading the solution into the semiconductor particle layer and forming the charge transfer layer thereon, and setting the counter electrode on the charge transfer layer.

In the former case, may be used as a method for spreading the electrolyte solution into the voids between the semiconductor particle layer and the counter electrode are a normal pressure method utilizing a capillarity, and a reduced pressure method which comprises pumping up the solution from the upper open-ends between the semiconductor particle layer and the counter electrode, not soaked in the solution.

In the latter case, an wet-type charge transfer layer may be applied the counter electrode thereon before drying, and then a treatment for preventing liquid-leakage is carried out at the edges thereof. On the other hand, charge transfer layer comprising a gel electrolyte may be coated in a liquid state, gelled by polymerization, etc., and applied the counter electrode thereon, or may be gelled after the application of the counter electrode thereon. Examples of a method for forming a charge transfer layer comprising an wet-type organic hole transporting material or a gel electrolyte include a soaking method, a roller method, a dip method, an air-knife method, an extrusion method, a slide-hopper method, a wire-bar method, a spin method, a spray method, a cast method, various printing methods, etc. similarly to the case of forming the semiconductor particle layer, or adsorbing a dye mentioned above. A charge transfer layer comprising a solid electrolyte or a solid hole transporting material may be formed by a dry film-forming method such as a vacuum deposition method and a CVD method, and followed by applying the counter electrode thereon.

In the case of forming the charge transfer layer comprising an electrolysis solution or a wet-type hole transporting material that is difficult to be solidified, it is preferable that the edges of the layer is sealed rapidly after coating. On the other hand, in the case of forming the charge transfer layer comprising a hole transporting material which is able to be solidified, it is preferable that the hole transfer layer according to a wet-type application, and then the material is solidified by photo-polymerization, thermal radical polymerization, etc. As mentioned, a method for forming the charge transfer layer may be properly selected in accordance with physical properties of the electrolyte and production conditions.

The water content of the charge transfer layer is preferably 10,000 ppm or less, more preferably 2,000 ppm or less, and particularly preferably 100 ppm or less.

### (D) Counter electrode

When the photoelectric conversion device of the present invention is applied to a photoelectric cell, the counter electrode acts as an anode of the cell. The counter electrode may be a single layer structure of a counter conductive layer comprising an electrically conductive material, or composed of the counter electrically conductive layer and a support, similarly to the above-descnbed conductive support. Examples of the material for the counter electrically conductive layer include metals such as platinum, gold, silver, copper, aluminum, rhodium and indium, carbon, electrically conductive metal oxides such as indium-tin composite oxides, fluorine-doped tin oxides, etc. The substrate for the counter electrode is preferably made of glass or plastic, and the electrically conductive layer is coated or vapor-deposited thereon. The thickness of the counter electrically conductive layer is not limited in particular, preferably 3 nm to 10 µm. In the case of the metal counter electrically conductive layer, the thickness thereof is preferably 5 µm or less, more preferably 5 nm to 3 µm.

Because any one or both of the conductive support and the counter electrode may be irradiated, at least one of them may be substantially transparent to have light reached to the photosensitive iayer. From a viewpoint of improving an electric generation efficiency, the conductive support is preferably transparent, and light is irradiated from the side thereof. In this case, the counter electrode preferably has a light-reflective property. Such a counter electrode may be made of glass or plastic having vapor-deposited metal or electrically conductive oxides thereon, or a metal.

The counter electrode may be (i) applied on the charge transfer layer formed beforehand, or (ii) placed on the semiconductor particle layer through a spacer before forming the charge transfer layer. In the case (i), the electrically conductive material may be coated, metal-plated, or vapor-deposited (PVD, CVD, etc.) directly on the charge transfer layer, or the electrically conductive layer composing the counter electrode may be laminated on the charge transfer layer. In the case (ii), the counter electrode may be settled on the semiconductor particle layer through the spacer, and the open ends between the electrode and the semiconductor layer is soaked in an electrolysis solution. The electrolysis solution penetrates into the voids between the counter electrode and the semiconductor particle layer, utilizing capillarity or reduced pressure. The electrolyte molecules may be cross-linked by heating, etc., if necessary. Similar to the case of the conductive support, it is preferable to use the metal lead for reducing resistance of the electrode particularly in the case where the counter electrode is transparent. Further, preferable materials of the metal lead, preferable methods for setting the metal lead, preferable reduced-degree of the incident light amount caused by the metal lead, etc. are the same as the case of the conductive support, mentioned above.

### (E) Other Layers

Functional layers such as a protective layer and a reflection-preventing layer may be formed on one of or both of the conductive support and the counter electrode each acting as the electrode. In the case where such functional layers are formed in a fashion of multi layers, they may be formed by a simultaneous multi-layer coating method or a successive coating method. The simultaneous multi-layer coating method is preferred from a viewpoint of productivity. A slide-hopper method and an extrusion method are suitable from the viewpoint of both productivity and homogeneity of a coated film for the simultaneous multi-layer coating method. The functional layers may be formed by a vapor-deposition method and a sticking method, and these methods may be selected in accordance with the materials for the layer.

### (F) Specific examples of interior structure of photoelectric conversion device

As described above, the photoelectric conversion device may have various interior structures in accordance with an end of use. These structures are classified into two major forms composed of a structure allowing incidence of light from both faces, and a structure allowing it from only one face. Fig. 2 to 9 illustrate examples of the interior structure of the photoelectric conversion device that can be preferably used in the present invention.

Fig. 2 illustrates a preferable structure of a photoelectric conversion device of the present invention, where a photosensitive layer 20 and a charge transfer layer 30 formed between a transparent electrically conductive layer 10a and a transparent counter electrically conductive layer 40a. This structure allows incidence of light from both faces of the photoelectric conversion device.

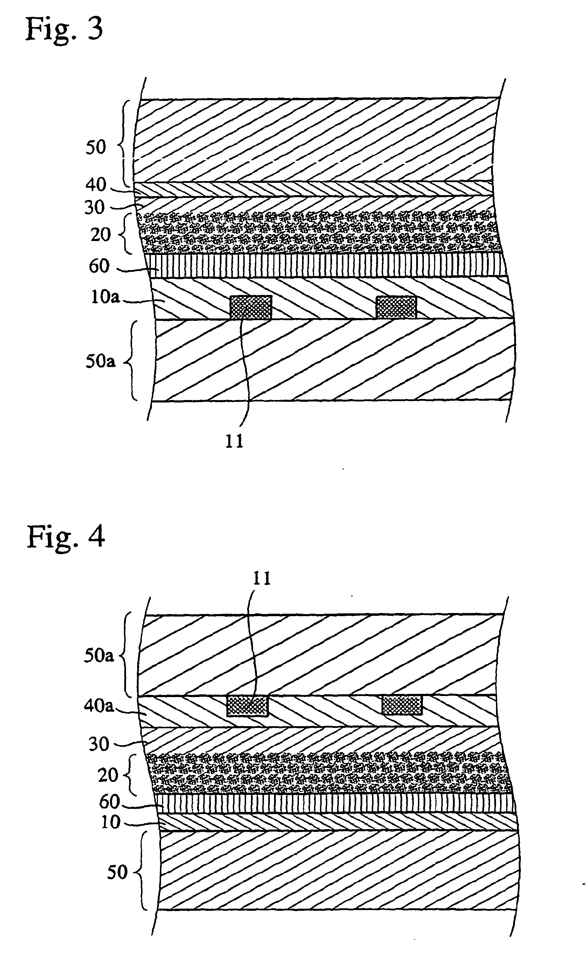

Fig. 3 illustrates a preferable structure of a photoelectric conversion device of the present invention, where on a transparent substrate 50a partially having a metal lead 11 is formed a transparent electrically conductive layer 10a, an undercoating layer 60, a photosensitive layer 20, a charge transfer layer 30 and a counter electrically conductive layer 40 are laminated thereon in this order, and a substrate 50 is further set thereon. This structure allows incidence of light from the electrically conductive layer side.

Fig. 4 illustrates a preferable structure of a photoelectric conversion device of the present invention, where a photosensitive layer 20 is applied on a substrate 50 having an electrically conductive layer 10 thereon through an undercoating layer 60, a charge transfer layer 30 and a transparent counter electrically conductive layer 40a are formed thereon, and further a transparent substrate 50a locally having a metal lead 11 thereon is placed so that the metal lead 11 side orients inward. This structure allows incidence of light from the counter electrode side.

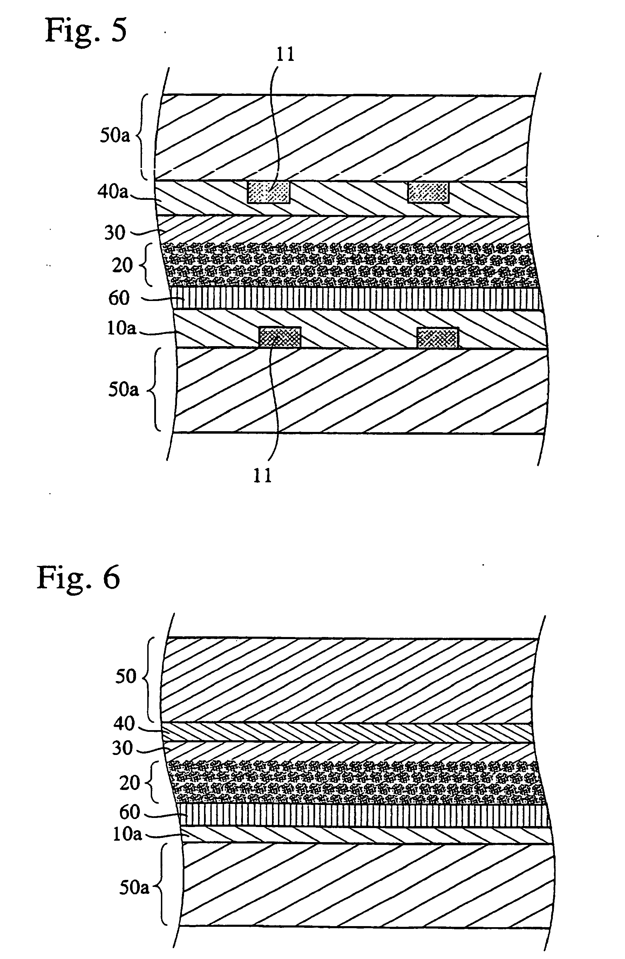

Fig. 5 illustrates a preferable structure of a photoelectric conversion device of the present invention, where on two transparent substrates 50 each having a metal lead 11 partially are formed a transparent electrically conductive layer 10a or a transparent counter electrically conductive layer 40a, respectively, and an undercoating layer 60, a photosensitive layer 20 and a charge transfer layer 30 placed between the conductive layers. This structure allows incidence of light from both faces of the photoelectric conversion device.

Fig. 6 illustrates a preferable structure of a photoelectric conversion device of the present invention, where on a transparent substrate 50a having a transparent electrically conductive layer 10a thereon is formed a photosensitive layer 20 through an undercoating layer 60, a charge transfer layer 30 and a counter electrically conductive layer 40 are applied thereon, and further a substrate 50 is placed thereon. This structure allows incidence of light from the electrically conductive layer side.

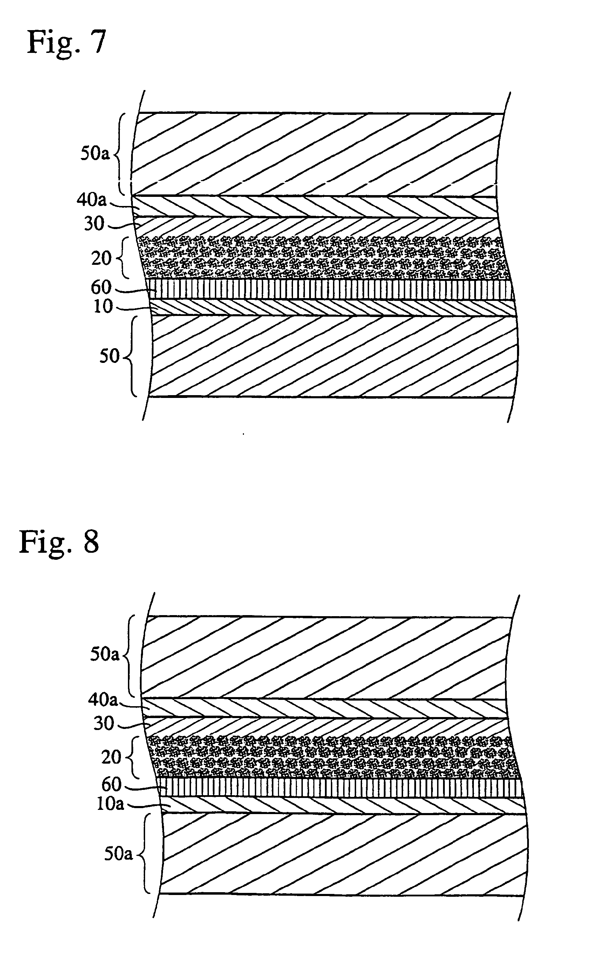

Fig. 7 illustrates a preferable structure of a photoelectric conversion device of the present invention, where on a substrate 50 having an electrically conductive layer 10 thereon is applied a photosensitive layer 20 through an undercoating layer 60, a charge transfer layer 30 and a transparent counter electrically conductive layer 40a are applied thereon, and further a transparent substrate 50a is placed thereon. This structure allows incidence of light from the counter electrode side.

Fig. 8 illustrates a preferable structure of a photoelectric conversion device of the present invention, where on a transparent substrate 50a having a transparent electrically conductive layer 10a thereon is applied a photosensitive layer 20 through an undercoating layer 60, a charge transfer layer 30 and a transparent counter electrically conductive layer 40a are applied thereon, and further a transparent substrate 50a is placed thereon. This structure allows incidence of light from both faces of the photoelectric conversion device.

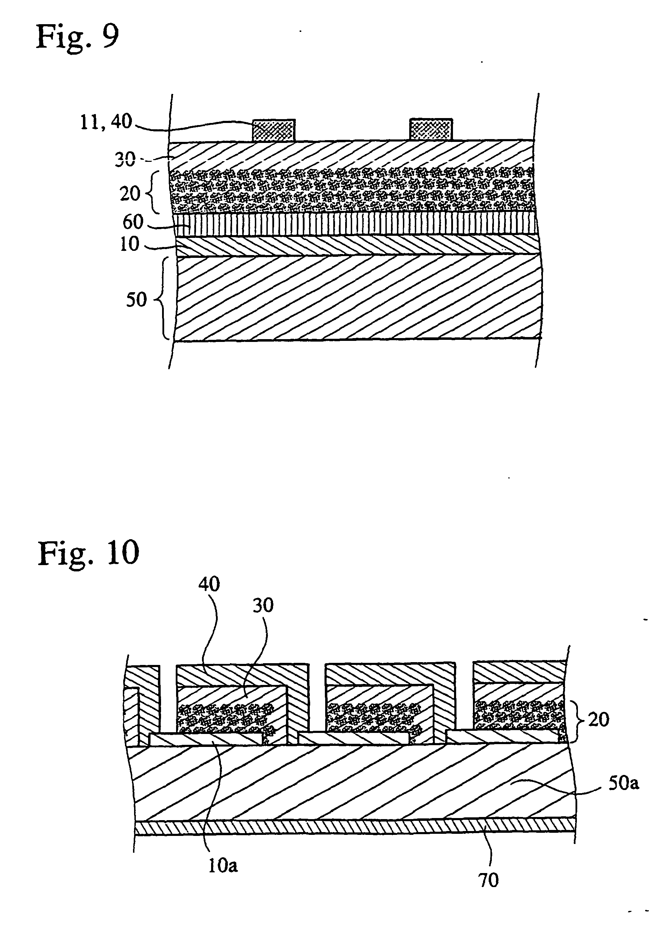

Fig. 9 illustrates a preferable structure of a photoelectric conversion device of the present invention, where on a substrate 50 having an electrically conductive layer 10 thereon is applied a photosensitive layer 20 through an undercoating layer, a solid charge transfer layer 30 is applied thereon, and further a counter electrically conductive layer 40 or a metal lead 11 is locally applied thereon. This structure allows incidence of light from the counter electrode side.

### [3] Photoelectric cell

The photoelectric cell of the present invention comprises the above-described photoelectric conversion device that is designed to work in the outer circuit. The photoelectric cell having the charge transfer layer comprising ionic conductive electrolyte is characterized as a kind of so-called photo-electrochemical cell. The side face of the photoelectric cell is preferably sealed with a polymer or an adhesive agent, etc. to prevent deterioration of the compositions thereof and volatility of the content in the cell. The outer circuit is connected to the conductive support and the counter electrode via a lead. Various known circuits may be used in the present invention.

### [4] Dye-sensitized solar cell

In the case where the photoelectric conversion device of the present invention is applied to a so-called solar cell, the interior structure of the photoelectric conversion device may be essentially the same as above. Module structures of the solar cell comprising the photoelectric conversion device of the present invention will be explained below.

The dye-sensitized solar cell of the present invention may have essentially the same module structure as that of prior art solar cells. The solar cell module generally has a structure where a cell is formed on a substrate made of metal, ceramic, etc., they are covered with a packing resin, a protective glass, etc., and light is introduced from an opposite side of the substrate. In addition, the solar cell module may have a structure where a cell is formed on a substrate made of a transparent material such as a tempered glass, and light is introduced from the transparent substrate side. Specifically known as a module structure are structures that are called "superstraight type", "substrate type" or "potting type", substrate-integrated type structure used for an amorphous silicon solar cell, etc. The dye-sensitized solar cell of the present invention may have a module structure properly selected from the above structures in accordance with ends, places and environment at use.

The super straight type modules and the substrate type modules generally have a structure where cells are set at a regular intervals between substrates, adjoining cells are connected by a metal lead, a flexible wirering, etc., and collector electrodes are set at the outer marginal portion so that a generated electric power can be delivered to the outside. One or both side of the substrates is transparent and subjected to a reflection-preventing treatment. Various kinds of plastic material such as ethylene vinyl acetate (EVA) may be contained between the substrate and the cell to protect the cell or to improve a collector efficiency. Such a plastic material is may be used in a form of a film or a packing resin. In the case of the solar cell used at a place where the surface of the cell is not necessarily covered with a hard material, such as a place without a shock from the outside, the substrate of one side can be omitted by forming a surface protective layer composed of a transparent plastic film, or by hardening the above-described packing resin to give a protection function. To seal the interior of the cell and to secure rigidity of a module, the periphery of the substrates may be sandwiched and fixed by metallic flames, and the substrates and the flames may be sealed with a sealant. Further, flexible materials may be used for the cell proper, the substrate, the packing agent and the sealant to constructing the solar cell on a curved surface.

For example, the super straight type solar cell module may be manufactured by the following steps of: placing cells on a front substrate sent out from a substrate-supplying device together with lead lines for connecting a sealant to the cells and a sealant for back surface while carrying the front substrate by a belt conveyer, etc.; placing a back substrate or a back cover thereon; and setting flames at the outer edge portion.

The substrate type solar cell may be manufactured by the following steps of: placing cells on a substrate sent out from a substrate-supplying device together with lead lines for connecting the cells and a sealant, etc. while carrying the substrate by a belt conveyer, etc.; placing a front cover thereon; and setting flames at the outer edge portion.

Fig. 10 shows structure of an embodiment of the substrate-integrated type solar cell produced by modularizing a photoelectric conversion device of the present invention. The solar cell shown in Fig. 10 has a structure where cells having a transparent electrically conductive layer 10a, a photosensitive layer 20 containing dye-adsorbed TiO₂ a solid charge transfer layer 30 and a metal counter electrically conductive layer 40 are modularized on one surface of a transparent substrate 50a, and a reflection-preventing layer 70 is applied on the other surface of the substrate. In such a structure, it is preferable to increase an area ratio of the photosensitive layer 20 observed from the substrate 50a side for enhancing an efficiency of utilizing incident light.

As for the solar cell shown in Fig. 10, a desired module structure can be obtained by patterning according to a semiconductor process technique such as selective metal plating, selective etching, CVD, PVD, etc., or a mechanical method such as laser scribing, plasma CVM, polishing, etc. so that the transparent electrically conductive layers, the photosensitive layers, the charge transfer layers and the counter electrode etc. are three-dimensionally arranged at a regular interval on the substrate. The plasma CVM is described in Solar Energy Materials and Solar Cells, 48, p 373 to 381, etc.

Other materials and processes used in the cell of the present invention will be described in detail below.

As a material for the sealant, various materials such as a liquid EVA (ethylene vinyl acetate), an EVA film, a mixture of fluorinated vinylidene copolymer and an acrylic resin, etc. may be used in accordance with objects such as application of weather-resistance or electric insulation, improvement in light-condensing efficiency, protection of a cell (improvement in impact resistance), etc. The outer edge of the module and the frame surrounding the fringe are preferably sealed with the sealant having high weather-resistance and moisture permeability. The strength and light transmittance of the sealed cell can be enhanced by adding a transparent filter into the sealant.

When the sealant is fixed on the cell, a method suited to a property of the sealant is preferably used. Various methods therefor may be used such as roll pressurization followed by thermal adherence, vacuum pressurization followed by thermal adherence, etc. for the film sealant, and roll coat, bar coat, spray coat, screen printing, etc. for the liquid or paste sealant.

It is preferable that a flexible material such as PET and PEN is used for a substrate, because after constructing the cells on a roll-like support, the sealing layer can be successively laminated according to the above-described methods to obtain a high productivity.

To increase a production efficiency of electric power, the light-taking surface of the substrate, generally a tempered glass substrate, of the module may be subjected to a reflection-preventing treatment.

The reflection-preventing treatment may comprise laminating a reflection-preventing film, coating a reflection-preventing layer, etc.

The surface of the solar cell may be grooved or textured, thereby enhancing efficiency of utilizing incident light.

To increase a production efficiency of electric power, it is most important to taking light in the module without a loss, and it is also important to reflect light reached to the inside of the solar cell through a photoelectric conversion layer, and return effectively to the layer.

The light reflectance may be increased by vapor-depositing or metal-plating the substrate with Ag, Al, etc. after a mirror plane-polishing, applying a layer comprising an Al-Mg alloy, an Al-Ti alloy, etc. as reflective layer at the lowest layer in the solar cell, making the lowest layer to a texture structure by annealing.

To increase the production efficiency of electric power, it is important to minimize a resistance of connection between cells, thereby preventing reduction in an inner voltage. The cells are generally connected each other by a wire bonding method or using an electrically conductive flexible sheet. In addition, the cells may be connected by methods such as electrically connecting while fixing the cells by an electrically conductive adhesives, adhesive tapes, etc., and pattern-coating an electrically conductive hot melt at an intended position.

A solar cell comprising a flexible support made of a polymer film, etc. may be manufactured by a method comprising the steps: forming cells in the same manner as described above while sending out a roll-like support; cutting it to an intended size; and sealing the marginal portion thereof with a flexible, moisture permeable material. The solar cell may have a module structure called "SCAF" described in Solar Energy Materials and Solar Cells, 48, p 383 to 391. Further, the solar cell comprising the flexible support may be used while adhered and fixed to a curved glass, etc.

As described above in detail, the solar cells comprising the photoelectric conversion device of the present invention may have various kinds of forms and functions in accordance with ends of use and environment of use.

### EXAMPLES

The present invention will be explained in more detail with reference to examples below.

### EXAMPLE 1

### Synthesis of metal complex dye

Specific methods for synthesizing the metal complex dyes D-1, D-7, D-2, D-8, D-3, D-9, D-35, and D-39 of the present invention will be explained below. Incidentally, a carboxylate ion and a carboxyl group in the molecular formulae illustrated below may exist in equilibrium with each other, and a structure of counter ion may be changed depending on the equilibrium state.

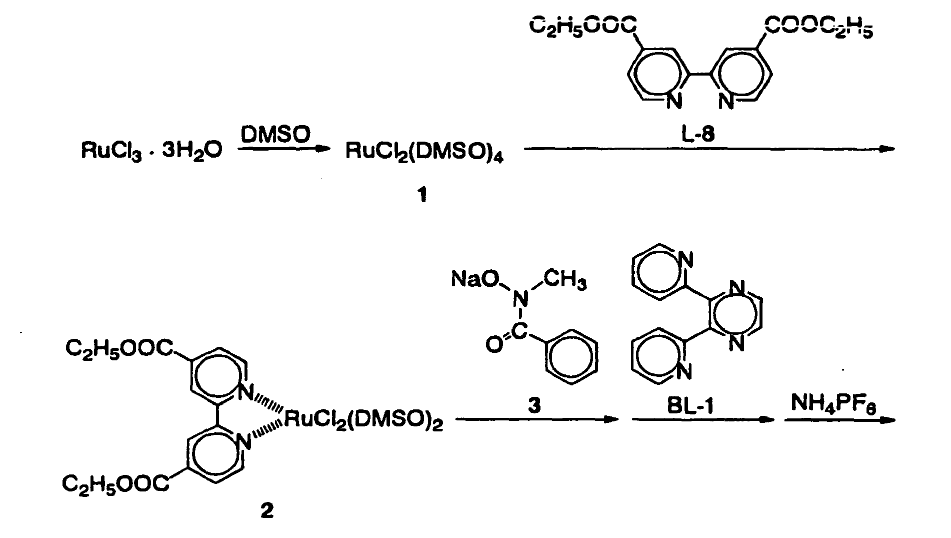

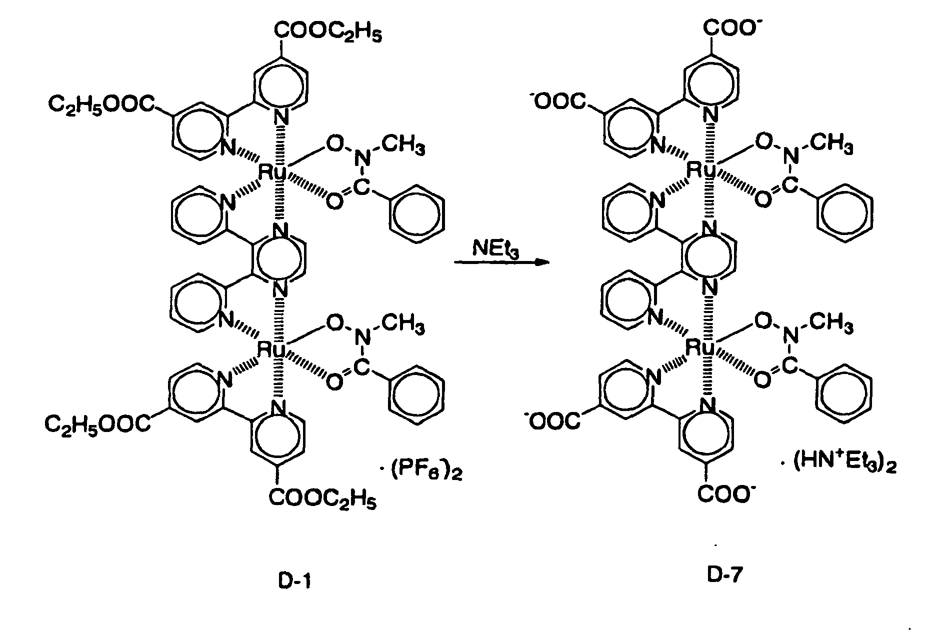

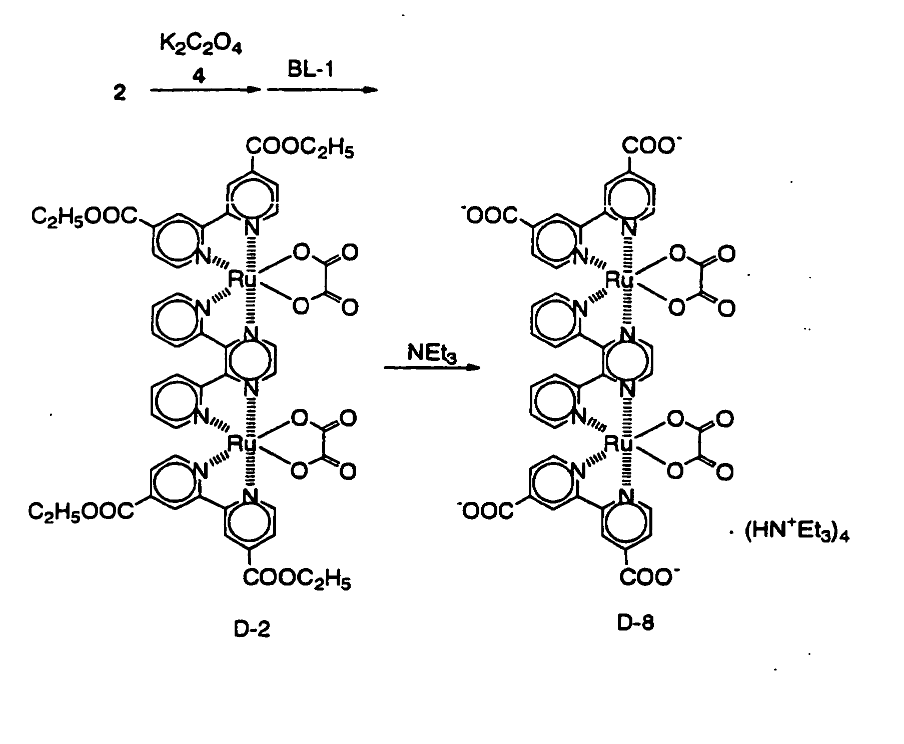

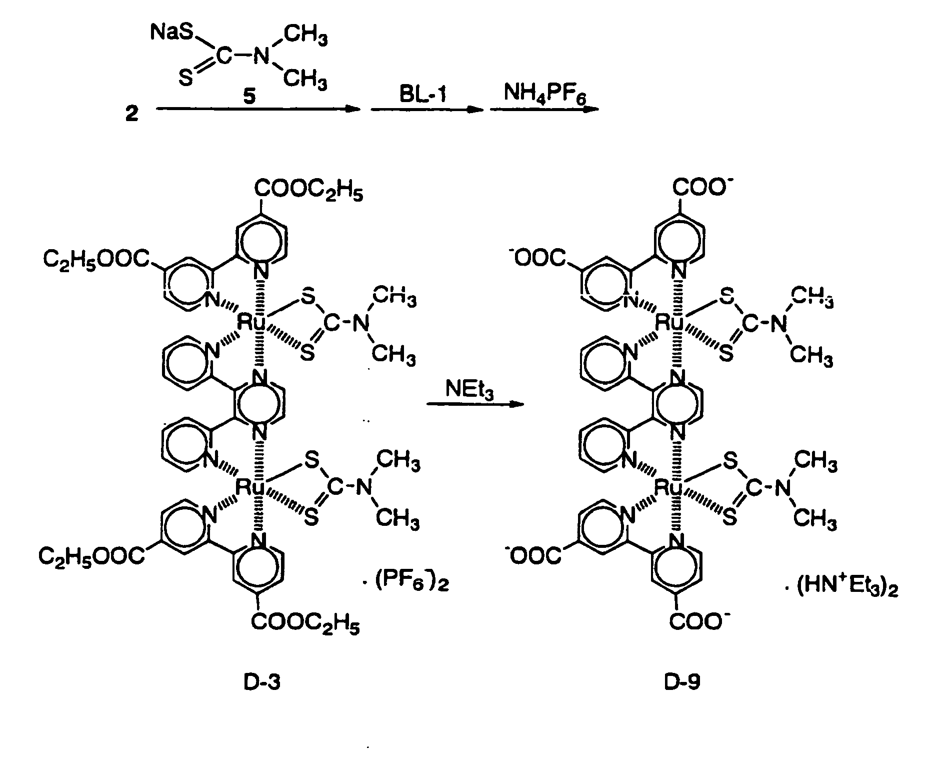

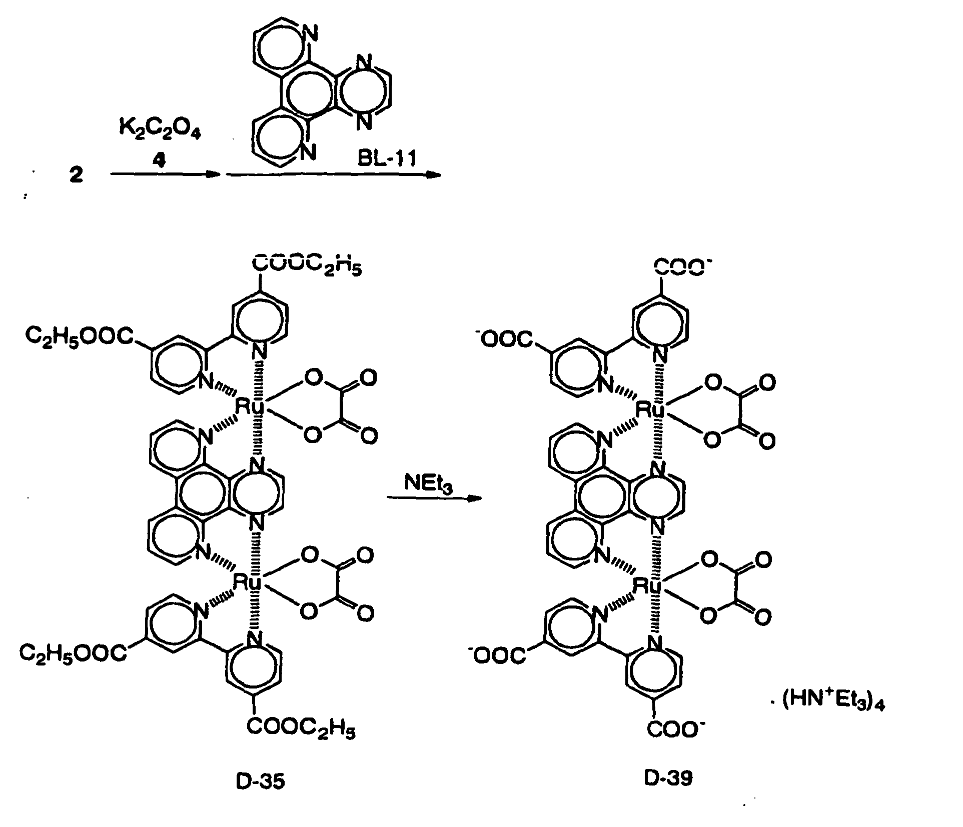

### (A) Syntheses of D-1 and D-7

10.44 g (40 mmol) of ruthenium (III) chloride trihydrate was dissolved in 50 ml of dimethyl sulfoxide (DMSO), and resultant solution was refluxed for 5 minutes. The solution was concentrated to 25 ml, and 200 ml of acetone was added thereto. The solution was filtered after cooling, and resulting crystal was washed with acetone and ether to obtain 13.9 g of ruthenium complex **1** (yellow crystal, 72 % yield).

0.87 g (1.8 mmol) of ruthenium complex **1** and 0.54 g (1.8 mmol) of diethoxycarbonyl bipyridine L-8 were dissolved in 5 ml of chloroform, and this solution was refluxed for 4 hours under nitrogen. After concentration, residue was dissolved in a small quantity of acetone, and to this was added ether to deposit precipitates. The solution was filtered and resulting crystal was washed with ether to obtain 0.85 g of ruthenium complex 2 (yellow crystal, 75 % yield).

0.166 g (0.264 mmol) of ruthenium complex **2** and 0.050 g (0.29 mmol) of sodium hydroxamate **3** were dissolved in a mixed solvent composed of 10 ml of ethanol and 10 ml of water, and the solution was refluxed for 2 hours under nitrogen. To this was added 0.028 g (0.12 mmol) of dipyridyl pyrazine BL-1, and the solution was refluxed for 20 hours. The reaction mixture was concentrated after adding 0.20 g of NH₄PF₆ thereto, and filtered. The resultant mixture was washed with water, and purified by column chromatography using Sephadex column LH-20 (developing solvent: methanol) to obtain 0.18 g of the metal complex dye D-1 (black crystal, 92 % yield). The structure of the product was identified by MS spectra and elemental analysis.

0.081 g (0.05 mmol) of D-1, 6 ml of triethylamine, 18 ml of dimethyl formamide (DMF) and 3 ml of water were mixed and refluxed for 12 hours. After concentration, residue was dispersed in acetonitrile and - filtered to obtain 0.06 g of D-7 (black crystal, 85 % yield). The structure of the product was identified by MS spectra and elemental analysis.

### (B) Syntheses of D-2 and D-8

The metal complex dye D-2 and D-8 were synthesized in the same manner as syntheses of D-1 and D-7 except that potassium oxalate 4 was used in place of sodium hydroxamate 3 in the same molar amount and that NH₄PF₆ was not added to the reaction mixture. The structures of the products were identified by MS spectra and elemental analysis.

### (C) Syntheses of D-3 and D-9

The metal complex dye D-3 and D-9 were synthesized in the same manner as syntheses of D-1 and D-7 except for using sodium dithiocarbamate **5** in place of sodium hydroxamate **3** in the same molar amount. The structures of the products were identified by MS spectra and elemental analysis.

### (D) Syntheses of D-35 and D-39

The metal complex dye D-35 and D-39 were synthesized in the same manner as syntheses of D-2 and D-8 except for using BL-11 synthesized by a method described in J. Am. Chem. Soc., 109, 2691 (1987) in place of dipyridyl pyrazine BL-1 in the same molar amount. The structures of the products were identified by MS spectra and elemental analysis.

### (G) Syntheses of other dyes

The metal complex dyes represented by the general formula (I) according to the present invention other than the above-described dyes can be also easily synthesized by using suitable ligands in a similar method to above. Compounds used for the ligands are commercially available, or can be easily synthesized referring to Inorg. Chim. Acta., 206, 69 (1993), Inorg. Chem., 29, 1888 (1990), J. Am. Chem. Soc., 109, 2691 (1987), Inorg. Chem., 29, 4750 (1990), Inorg. Chem., 28, 1520 (1989), Inorg. Chem., 29, 167 (1990), Inorg. Chem., 28, 2465 (1989), Chem. Eur. J., 1292 (1996), Angew. Chem. Int. Ed. Engl., 34, 1122 (1995), Inorg. Chim. Acta., 154, 77 (1988), Inorg. Chem., 28, 370 (1989), Inorg. Chem., 32, 194 (1993), J. Org. Chem., 62, 1491 (1997), Chem. Commun., 1707 (1996), etc. or references therein. A substituent such as a carboxyl group, etc. can be introduced to the compound according to routine method.

### EXAMPLE 2

### Measurement of absorption spectrum

With regards to D-7, D-8, D-9, D-10, D-38, D-39, D-40, D-41 and comparative dyes 1 and 2, absorption spectrum in methanol was measured. Maximum absorption wavelengths according to these dyes are shown in Table 1.

**Table 1**

| Metal Complex Dye | Maximum Absorption Wavelength (in MeOH, nm) |
|---|---|
| D-7 | 574 |
| D-8 | 588 |
| D-9 | 588 |
| D-10 | 569 |
| D-38 | 650, 504 |
| D-39 | 655, 530 |
| D-40 | 660, 480 |
| D-41 | 625,482 |
| Comparative Dye 1 | 532 |
| Comparative Dye 2 | 450 |

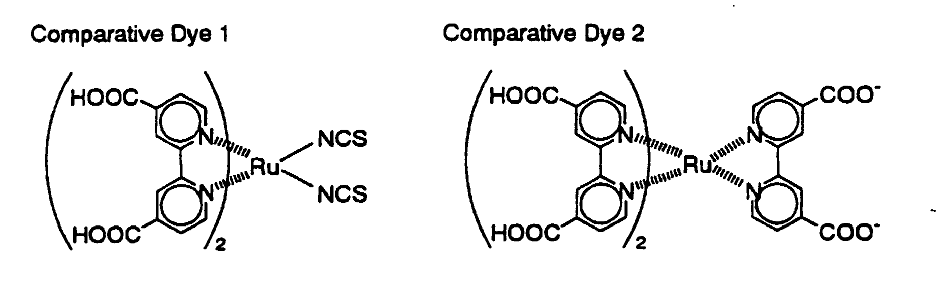

As shown in Table 1, the metal complex dye used in the present invention had a maximum absorption wavelength longer than those of the comparative dyes 1 and 2. Accordingly, the photoelectric cell utilizing the metal complex dye of the present invention can efficiently convert in longer wavelength light into electricity as compared with a prior art.

### EXAMPLE 3

### Preparation of photoelectric cell and measurement of photoelectric - - conversion efficiency

A stainless steel vessel coated with Teflon inside and having an inner volume of 200 ml was charged with 15 g of titanium dioxide Degussa P-25 manufactured by Nippon Aerosil K.K., 45 g of water, 1 g of dispersant Triton X-100 manufactured by Aldrich, and 30 g of zirconia beads having a diameter of 0.5 mm manufactured by Nikkato K.K. These contents were subjected to a dispersion treatment at 1500 rpm for 2 hours by means of a sand-grinder mill manufactured by Imex K.K. The zirconia beads were removed by filtration to obtain the titanium dioxide dispersion. The average particle diameter of the titanium dioxide particles in the dispersion was 2.5 µm. The particle diameter was measured by Master Sizer manufactured by MALVERN.

The above-described dispersion was coated on an electrically conductive surface of a conductive glass having a fluorine-doped tin oxide layer thereon by a doctor blade. This conductive glass manufactured by Nippon Sheet Glass Co., Ltd. had a surface resistance of approximately 10 Ω/square. A coating thickness of the dispersion was 140 µm in wet state, and a coating amount of the semiconductor particles was 15 g/m². The coated glasses were air-dried for 30 minutes at 25 °C. Then, the glasses were placed in an electric furnace (muffle furnace FP-32, manufactured by - Yamato Science K.K.), followed by calcinating at 450 °C for 30 minutes to obtain TiO₂ electrodes. After the electrodes were taken out of the furnace and cooled, they were immersed in the methanol solution comprising the metal complex dye shown in Table 2 for 3 hours to adsorbing the dye, respectively. The concentration of the dye in the methanol solution was 3 × 10⁻⁴ mol/l. The dye-adsorbed TiO² electrodes were further immersed in 4-t-butylpyridine for 15 minutes, then washed with methanol and air-dried. The thickness of thus-obtained photosensitive layer was 10 µm, and an adsorbed amount of the metal complex dye was 0.1 to 10 mmol/m².

The 20 mm × 20 mm of dye-sensitized TiO² electrode glass substrate prepared as described above was put on platinum-vapor deposited glass having the same size as the TiO₂electrode through a spacer. Next, an electrolysis solution comprising N-methyl-2-oxazolydinone, and 0.65 mol/l of 1-butyl-3-methylimidazolium iodide and 0.05 mol/l of iodine as an electrolyte was permeated into a crevice between the glasses through caplliariiy to be introduced into the TiO₂ electrode, thereby obtaining a photoelectric cell. According to this example, the photoelectric cell as shown in Fig. 1 was prepared, where the conductive support of the electrically conductive glass comprising the transparent substrate 50a of glass and the electrically conductive layer 10a applied thereon, the photosensitive layer 20 of the dye-sensitized TiO₂ the charge transfer layer 30 of the above-described electrolysis solution, the counter electrically conductive layer 40 of platinum, and the transparent substrate 50a of glass were laminated in this order, and sealed with an epoxy-based sealant.

With respect to the photoelectric cells, the photoelectric conversion efficiency to light at 800 nm was measured by IPCE (Incident Photon to Current Conversion Efficiency) measuring instrument manufactured by Optel Co. The results are shown in Table 2.

**Table 2**

| Metal Complex Dye | IPCE (800nm. %) |
|---|---|
| D-4 | 2 |
| D-10 | 9 |
| D-13 | 25 |
| D-14 | 24 |
| D-15 | 22 |
| D-29 | 21 |
| D-30 | 25 |
| D-35 | 2 |
| D-39 | 8 |
| D-45 | 23 |
| D-50 | 21 |
| D-57 | 19 |
| D-61 | 20 |
| Comparative Dye 1 | 0 |
| Comparative Dye 2 | 0 |

### EXAMPLE 4

### Preparation of photoelectric cell and Measurement of photoelectric conversion efficiency

A stainless steel vessel coated with Teflon inside and having an inner volume of 200 ml was charged with 15 g of titanium dioxide Degussa P-25 manufactured by Nippon Aerosil K.K., 45 g of water, 1 g of dispersant Triton X-100 manufactured by Aldrich, and 30 g of zirconia beads having a diameter of 0.5 mm manufactured by Nikkato K.K. These contents were subjected to a dispersion treatment at 1500 rpm for 2 hours by means of a sand-grinder mill manufactured by Imex K.K. The zirconia beads were removed by filtration to obtain the titanium dioxide dispersion. The average particle diameter of the titanium dioxide particles in the dispersion was 2.5 µm. Incidentally, the particle diameter was measured by Master Sizer manufactured by MALVERN.

The above-described dispersion was coated on an electrically conductive surface of a conductive glass having a fluorine-doped tin oxide layer thereon by a glass bar. Used as the conductive glass was 20 mm × 20 mm of TCO Glass-U manufactured by Asahi Glass K.K. with surface resistance of approximately 30 Ω/square. A coating amount of the semiconductor particles was 20 g/m². Herein, on the eight glasses were coated the dispersion at once after adhesive tape was attached to a part of the conductive surface (3 mm from the edge) of each conductive glass as a spacer, and the glasses were arranged so that the adhesive tapes come to both edges thereof. The coated glasses were air-dried for one day at a room temperature after peeling the adhesive tapes. Next, the glasses were placed in an electric furnace (muffle furnace FP-32, manufactured by Yamato Science K.K.), followed by calcinating at 450°C for 30 minutes to obtain TiO₂ electrodes. After the electrodes were taken out of the furnace and cooled, they were immersed in the methanol solutions comprising the metal complex dye shown in Table 3 for 15 hours to adsorbing the dyes, respectively. The concentration of the dye in the methanol solution was 3 × 10⁻⁴ mol/l. The dye-adsorbed TiO₂ electrodes were further immersed in 4-t-butylpyridine for 15 minutes, then washed with ethanol and air-dried. The thickness of thus-obtained photosensitive layer was 10 µm.

The 20 mm × 20 mm of dye-sensitized TiO₂ electrode glass substrate prepared as described above was put on platinum-vapor deposited glass having the same size as the TiO₂ electrode. Then, an electrolysis solution comprising 3-methoxypropionitrile, and 0.65 mol/l of 1-methyl-3-hexylimidazolium iodide and 0.05 mol/l of iodine as an electrolyte was permeated into a crevice between the glasses through capillarity to be introduced into the TiO₂ electrode, thereby obtaining a photoelectric ceil. According to this example, the photoelectric cell as shown in Fig. 1 was prepared, where the conductive support of the electrically conductive glass _ comprising the transparent substrate 50a and the electrically conductive layer 10a applied thereon, the photosensitive layer 20 of the dye-sensitized TiO₂, the charge transfer layer 30 of the above-described electrolysis solution, the counter electrically conductive layer 40 of platinum, and the transparent substrate 50a of glass were laminated in this order, and sealed with an epoxy-based sealant.

With respect to the photoelectric cells, the photoelectric conversion efficiency to light at 800 nm was measured by IPCE (Incident Photon to Current Conversion Efficiency) measuring instrument manufactured by Optel Co. The results are shown in Table 3.

**Table 3**

| Metal Complex Dye | IPCE (800nm, %) |
|---|---|
| Comparative Dye 1 | 0 |
| Comparative Dye 2 | 0 |

As shown in Tables 2 and 3, because the comparative dyes 1 and 2 had no absorbability to light at 800 nm, the photoelectric cell using the dyes could not convert the light into electricity. As compared with this, the photoelectric cells utilizing the dyes represented by the general formula (I) of the present invention exhibited an excellent photoelectric conversion efficiency to such a long wavelength light.

As explained above in detail, the metal complex dye represented by the general formula (I) according to the present invention has a high absorbability against light in a large wavelength region containing visible region to infrared region. Consequently, the photoelectric conversion device utilizing the dye exhibits a high photoelectric conversion efficiency to a light in the visible region to the infrared region. The photoelectric cell comprising the device of the present invention is extremely useful as a solar cell.

## Claims

1. A photoelectric conversion device comprising semiconductor particles sensitized by a metal complex dye represented by the following general formula (I):
(LL₁)ₘ₁(X₁)ₘ₂M₁(BL)M₂(LL₂)ₘ₃(X₂)ₘ₄·Cl (1)
wherein M₁ and M₂ independently represent a metal atom; **characterized in that** BL is represented by any one of the following general formulae B-1 to B-4. 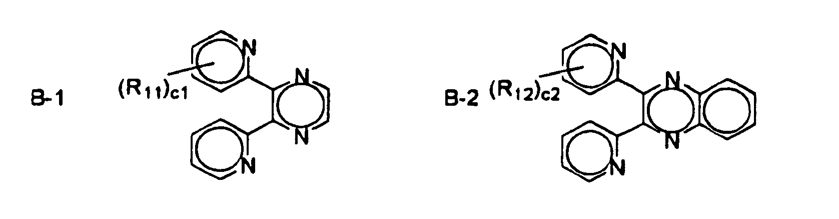 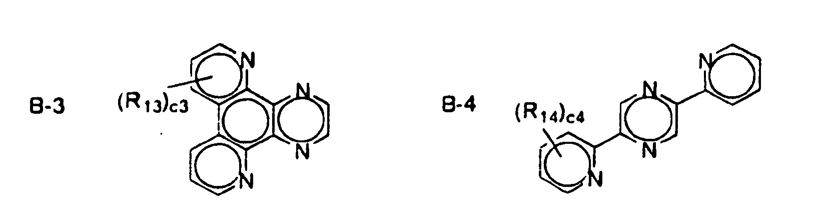 wherein R₁₁ to_R₁₄ independently represent a substituent that may be bonded to any carbon atom forming a ring, c1 to c4 independently represent an integer of 0 to 8.
LL₁ and LL₂ independently represent a bidentate ligand represented by the following wine general formula (II): 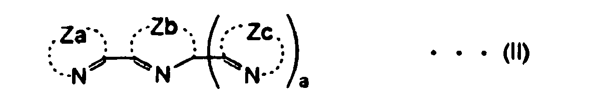 wherein Za, Zb and Zc independently represent nonmetallic atoms forming a 5- or 6-membered ring, *a* being 0;
X₁ and X₂ independently represent a monodentate or bidentate ligand which coordinates to said metal atom via one or two groups selected from the group consisting of an acyloxy group, an acylthio group, a thioacyloxy group, a thioacylthio group, an acylaminooxy group, a thiocarbamate group, a dithiocarbamate group, a thiocarbonate group, a dithiocarbonate group, a trithiocarbonate group, an acyl group, a thiocyanate group, an isothiocyanate group, a cyanate group, an isocyanate group, a cyano group, an alkylthio group, an arylthio group, an alkoxy group and an aryloxy group, or a monodentate or bidentate ligand selected from the group consisting of halogen atoms, carbonyl, dialkylketones, 1,3-diketones, carbonamides, thiocarbonamides and thioureas;
m 1 and m3 independently represent 0 or 1;
m2 represents an integer of 0 to 4, and X₁'s may be the same or different ligands that may be bonded together when m2 is 2 or more;
m4 represents an integer of 0 to 4, and X₂'s may be the same or different ligands that may be bonded together when m4 is 2 or more; and
CI represents a counter ion optionally contained to neutralize charge of said metal complex dye, wherein said M₁ and M₂ are Ru.

2. The photoelectric conversion device according to claim 1, wherein said R₁₁ to R₁₄ in said general formulae B-1 to independently represent an alkyl group, an alkenyl group, an aryl group, a hydroxyl group, an amino group, an alkoxycarbonyl group, a carboxyl group, a sulfonic acid group, a phosphoryl group, a phosphonyl group or a halogen atom.

3. The photoelectric conversion device according to any one of claims 1 , wherein said Za, Zb and Zc in said general formula (II) independently form a pyridine ring, a pyrimidine ring, a pyrazine ring, a pyridazine ring, a pyrazole ring, an imidazole ring, a triazole ring, a thiazole ring, an oxazole ring, a benzimidazole ring, a benzotriazole ring, a benzoxazole ring or a benzothiazole ring.

4. The photoelectric conversion device according to any one of claims 1 to 3, wherein said LL₁ and LL₂ independently represent a bidentate ligand represented by any one of the following general formulae (IV-1) to (IV-5): 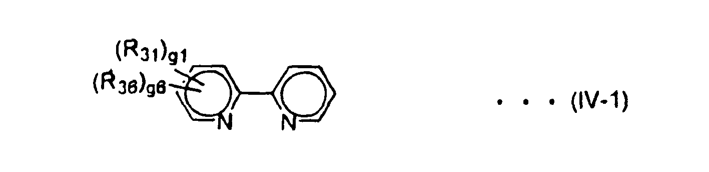 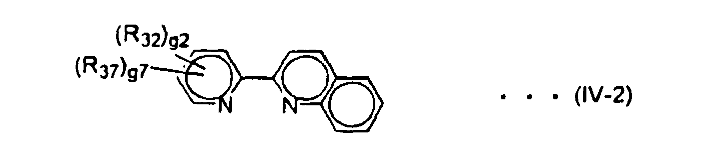 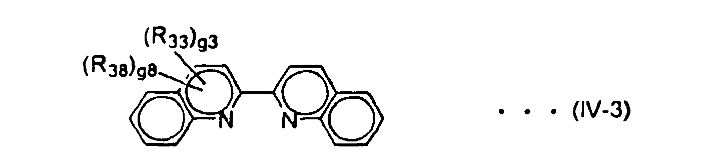 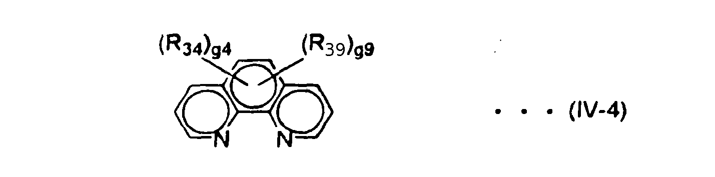 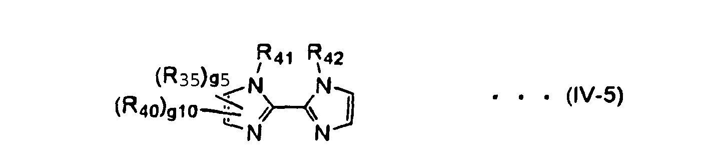 wherein R₃₁ to R₃₅ independently represent a carboxyl group, a sulfonic acid group, a hydroxyl group, a hydroxamic acid group, a phosphoryl group or a phosphonyl group, R₃₆ to R₄₀ independently represent a substituent, R₄₁ to R₄₂ independently represent a hydrogen atom, an alkyl group, an alkenyl group or an aryl group, R₃₁ to R₄₀ may be bonded to any carbon atom forming a ring, g1 to g5 and g10 independently represent an integer of 0 to 4, g6 to g9 independently represent an integer of 0 to 6, R₃₁'s to R₃₅'s may be the same or different groups when g1 to g5 are 2 or more, and R₃₆'s to R₄₀'s may be the same or different groups that may be bonded together to form a ring when g6 to g10 are 2 or more.

5. The photoelectric conversion device according to any one of claims 1 to 4, wherein said metal complex dye comprises at least one acidic group.

6. The photoelectric conversion device according to any one of claims 1 to 5, wherein said metal complex dye comprises at least one group selected from the group consisting of a carboxyl group, a sulfonic acid group, a hydroxyl group, a hydroxamic acid grout, a phosphoryl group and a phsphonyl group.

7. The photoelectric conversion device according to any one of claims 1 to 6, wherein said semiconductor particles are titanium oxide particles.

8. A photoelectric cell comprising said photoelectric conversion device according to any one of claims 1 to 7.

## Patentansprüche

1. Fotoelektrische Umwandlungsvorrichtung, umfassend Halbleiterteilchen, die durch einen Metallkomplexfarbstoff empfindlich gemacht worden sind, dargestellt durch die folgende allgemeine Formel (1):
(LL₁)ₘ₁(X₁)ₘ₂M1(BL)M₂(LL₂)ₘ₃(X₂)ₘ₄·Cl ··· (I)
wobei M₁ und M₂ unabhängig ein Metallatom darstellen; **dadurch gekennzeichnet, dass** BL durch eine der folgenden allgemeinen Formeln B-1 bis B-4 dargestellt ist: 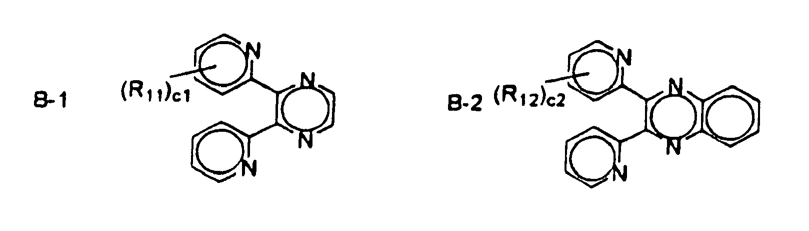 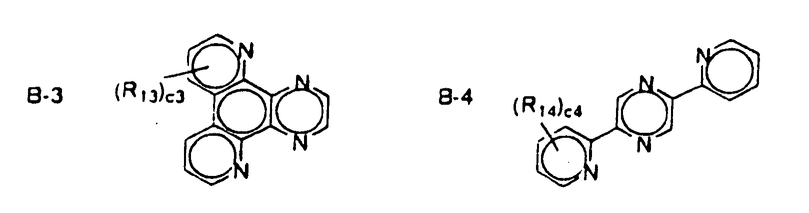 wobei R₁₁ bis R₁₄ unabhängig einen Substituenten, der an ein Kohlenstoffatom, das einen Ring bildet, gebunden sein kann, darstellen, c1 bis c4 unabhängig eine ganze Zahl von 0 bis 8 darstellen,
LL₁ und LL₂ unabhängig einen zweizähnigen Liganden darstellen, dargestellt durch die folgende allgemeine Formel (II): 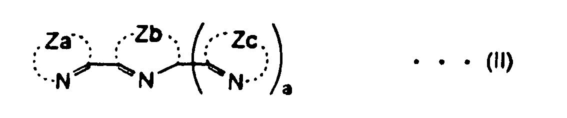 wobei Za, Zb und Zc unabhängig Nichtmetallatome, die einen 5- oder 6-gliedrigen Ring bilden, darstellen, a 0 ist;
X₁ und X₂ unabhängig einen einzähnigen oder zweizähnigen Liganden darstellen, welcher an das genannte Metallatom mit einer oder zwei Gruppen ausgewählt aus der Gruppe bestehend aus einer Acyloxygruppe, einer Acylthiogruppe, einer Thioacyloxygruppe, einer Thioacylthiogruppe, einer Acylaminooxygruppe, einer Thiocarbamatgruppe, einer Dithiocarbamatgruppe, einer Thiocarbonatgruppe, einer Dithiocarbonatgruppe, einer Trithiocarbonatgruppe, einer Acylgruppe, einer Thiocyanatgruppe, einer lsothiocyanatgruppe, einer Cyanatgruppe, einer lsocyanatgruppe, einer Cyanogruppe, einer Alkylthiogruppe, einer Arylthiogruppe, einer Alkoxygruppe und einer Aryloxygruppe koordiniert, oder ein einzähniger oder zweizähniger Ligand ausgewählt aus der Gruppe bestehend aus Halogenatomen, Carbonyl, Dialkylketonen, 1,3-Diketonen, Carbonamiden, Thiocarbonamiden und Thioharnstoffen;
m1 und m3 unabhängig 0 oder 1 sind;
m2 eine ganze Zahl von 0 bis 4 darstellt, und die Reste X₁ die gleichen oder unterschiedliche Liganden sein können, die zusammengebunden sein können, wenn m2 2 oder mehr ist;
m4 eine ganze Zahl von 0 bis 4 darstellt, und die Reste X₂ die gleichen oder unterschiedliche Liganden sein können, die zusammengebunden sein können, wenn m4 2 oder mehr ist; und
Cl ein Gegenion darstellt, das optional enthalten ist, um die Ladung von dem genannten Metallkomplexfarbstoff zu neutralisieren, wobei die genannten M₁ und M₂ Ru sind.

2. Fotoelektrische Umwandlungsvorrichtung nach Anspruch 1, wobei die genannten R₁₁ bis R₁₄ in den genannten allgemeinen Formeln B-1 bis B-4 unabhängig eine Alkylgruppe, eine Alkenylgruppe, eine Arylgruppe, eine Hydroxylgruppe, eine Alkoxygruppe, eine Aminogruppe, eine Alkoxycarbonylgruppe, eine Carbonsäuregruppe, eine Sulfonsäuregruppe, eine Phosphorylgruppe, eine Phosphonylgruppe oder ein Halogenatom darstellen.

3. Fotoelektrische Umwandlungsvorrichtung nach einem der Ansprüche 1 oder 2, wobei die genannten Za, Zb und Zc in der genannten allgemeinen Formel (II) unabhängig einen Pyridinring, einen Pyrimidinring, einen Pyrazinring, einen Pyridazinring, einen Pyrazolring, einen Imidazolring, einen Triazolring, einen Thiazolring, einen Oxazolring, einen Benzimidazolring, einen Benzotriazolring, einen Benzoxazolring oder einen Benzothiazolring bilden.

4. Fotoelektrische Umwandlungsvorrichtung nach einem der Ansprüche 1 bis 3, wobei die genannten LL₁ und LL₂ unabhängig einen zweizähnigen Liganden darstellen, dargestellt durch eine der folgenden allgemeinen Formeln (IV-1) bis (IV-5): 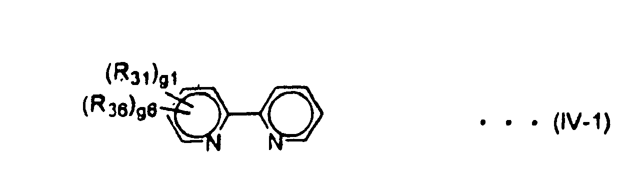 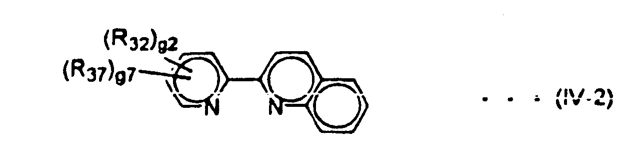 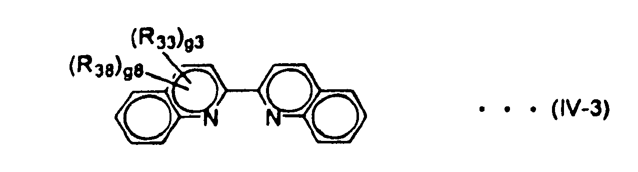 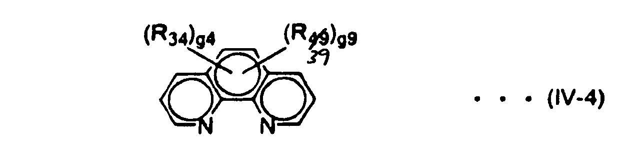 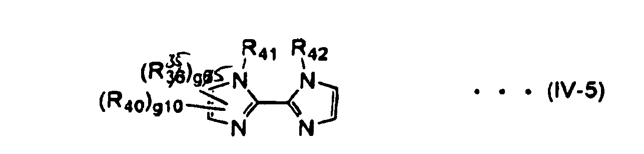 wobei R₃₁, bis R₃₅ unabhängig eine Carbonsäuregruppe, eine Sulfonsäuregruppe, eine Hydroxylgruppe, eine Hydroxamsäuregruppe, eine Phosphorylgruppe oder eine Phosphonylgruppe darstellen, R₃₆ bis R₄₀ unabhängig einen Substituenten darstellen, R₄₁ bis R₄₂ unabhängig ein Wasserstoffatom, eine Alkylgruppe, eine Alkenylgruppe oder eine Arylgruppe darstellen, R₃₁ bis R₄₀ an ein Kohlenstoffatom, das einen Ring bildet, gebunden sein können, g1 bis g5 und g10 unabhängig eine ganze Zahl von 0 bis 4 darstellen, g6 bis g9 unabhängig eine ganze Zahl von 0 bis 6 darstellen, die Reste R₃₁ bis R₃₅ die gleichen oder unterschiedliche Gruppen sein können, wenn g1 bis g5 2 oder mehr sind, und die Reste R₃₆ bis R₄₀ die gleichen oder unterschiedliche Gruppen sein können, die zusammengebunden sein können, um einen Ring zu bilden, wenn g6 bis g10 2 oder mehr sind.

5. Fotoelektrische Umwandlungsvorrichtung nach einem der Ansprüche 1 bis 4, wobei der genannte Metallkomplexfarbstoff mindestens eine saure Gruppe umfasst.

6. Fotoelektrische Umwandlungsvorrichtung nach einem der Ansprüche 1 bis 5, wobei der genannte Metallkomplexfarbstoff mindestens eine Gruppe ausgewählt aus der Gruppe bestehend aus einer Carbonsäuregruppe, einer Sulfonsäuregruppe, einer Hydroxylgruppe, einer Hydroxamsäuregruppe, einer Phosphorylgruppe und einer Phosphonylgruppe umfasst.

7. Fotoelektrische Umwandlungsvorrichtung nach einem der Ansprüche 1 bis 6, wobei die genannten Halbleiterteilchen Titanoxidteilchen sind.

8. Fotoelektrische Zelle, umfassend die genannte fotoelektrische Umwandlungsvorrichtung nach einem der Ansprüche 1 bis 7.

## Revendications

1. Dispositif de conversion photoélectrique comprenant des particules de semi-conducteur sensibilisées par un colorant de complexe métallique représenté par la formule générale (I) suivante :
(LL₁)ₘ₁(X₁)ₘ₂M₁(BL)M₂(LL₂)ₘ₃(X₂)ₘ₄·Cl (I)
dans laquelle M₁ et M₂ représentent indépendamment un atome de métal ; **caractérisé en ce que** BL est représenté par l'une des formules générales B-1 à B-4 suivantes 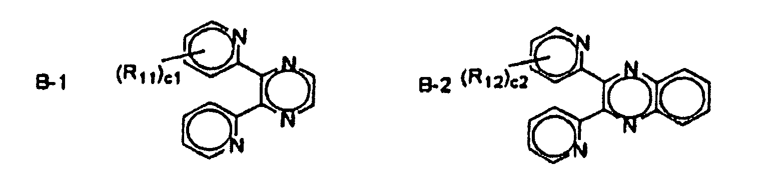 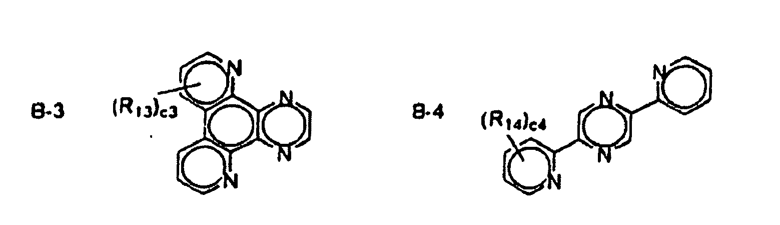 dans lesquelles R₁₁ à R₁₄ représentent indépendamment un substituant qui peut être lié à un atome de carbone quelconque formant un cycle, c1 à c4 représentent indépendamment un nombre entier de 0 à 8,
LL₁ et LL₂ représentent indépendamment un ligand bidenté représenté par la formule générale (II) suivante : 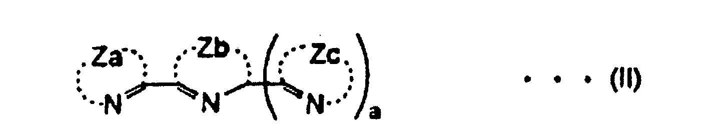 dans laquelle Za, Zb et Zc représentent indépendamment des atomes non métalliques formant un cycle à 5 ou 6 éléments, a étant égal à 0 ;
X₁ et X₂ représentent indépendamment un ligand monodenté ou bidenté qui est coordonné audit atome métallique via un ou deux groupes
choisis dans le groupe constitué d'un groupe acyloxy, d'un groupe acylthio, d'un groupe thioacyloxy, d'un groupe thioacylthio, d'un groupe acylaminooxy, d'un groupe thiocarbamate, d'un groupe dithiocarbamate, d'un groupe thiocarbonate, d'un groupe dithiocarbonate, d'un groupe trithiocarbonate, d'un groupe acyle, d'un groupe thiocyanate, d'un groupe isothiocyanate, d'un groupe cyanate, d'un groupe isocyanate, d'un groupe cyano, d'un groupe alkylthio, d'un groupe arylthio, d'un groupe alcoxy et d'un groupe aryloxy, ou un ligand monodenté ou bidenté choisi dans le groupe constitué d'atomes d'halogène, d'un groupe carbonyle, de dialkyl-cétones, de 1,3-dicétones, de carbonamides, de thiocarbonamides et de thiourées ;
m1 et m3 représentent indépendamment 0 ou 1 ;
m2 représente un nombre entier de 0 à 4, et les X₁ peuvent être des ligands identiques ou différents qui peuvent être liés ensemble lorsque m2 est égal à 2 ou plus ;
m4 représente un nombre entier de 0 à 4, et les X₂ peuvent être des ligands identiques ou différents qui peuvent être liés ensemble lorsque m4 est égal à 2 ou plus ; et
CI représente un contre-ion éventuellement contenu pour neutraliser la charge dudit colorant de complexe métallique, dans laquelle lesdits M₁ et M₂ sont Ru.

2. Dispositif de conversion photoélectrique selon la revendication 1, dans lequel lesdits R₁₁ à R₁₄ dans lesdites formules générales B-1 à B-4 représentent indépendamment un groupe alkyle, un groupe alcényle, un groupe aryle, un groupe hydroxyle, un groupe alcoxy, un groupe amino, un groupe alcoxycarbonyle, un groupe carboxyle, un groupe acide sulfonique, un groupe phosphoryle, un groupe phosphonyle ou un atome d'halogène.

3. Dispositif de conversion photoélectrique selon l'une quelconque des revendications 1 ou 2, dans lequel lesdits Za, Zb et Zc dans ladite formule générale (II) forment indépendamment un cycle pyridine, un cycle pyrimidine, un cycle pyrazine, un cycle pyridazine, un cycle pyrazole, un cycle imidazole, un cycle triazole, un cycle thiazole, un cycle oxazole, un cycle benzimidazole, un cycle benzotriazole, un cycle benzoxazole ou un cycle benzothiazole.

4. Dispositif de conversion photoélectrique selon l'une quelconque des revendications 1 à 3, dans lequel lesdits LL₁ et LL₂ représentent indépendamment un ligand bidenté représenté par l'une quelconque des formules générales (IV-1) à (IV-5) suivantes : 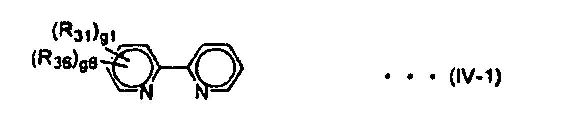 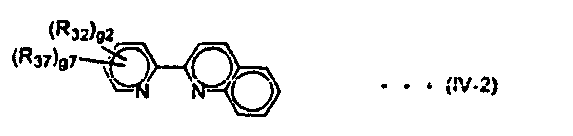 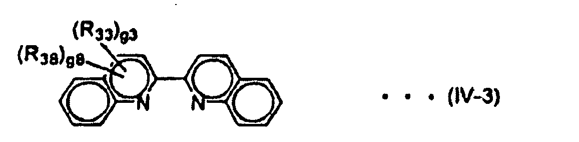 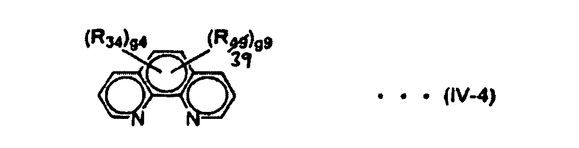 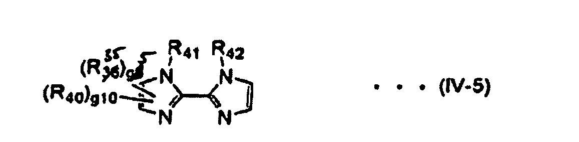 dans lesquelles R₃₁ à R₃₅ représentent indépendamment un groupe carboxyle, un groupe acide sulfonique, un groupe hydroxyle, un groupe acide hydroxamique, un groupe phosphoryle ou un groupe phosphonyle, R₃₆ à R₄₀ représentent indépendamment un substituant, R₄₁ à R₄₂ représentent indépendamment un atome d'hydrogène, un groupe alkyle, un groupe alcényle ou un groupe aryle, R₃₁ à R₄₀ peuvent être liés à un atome de carbone quelconque formant un cycle, g1 à g5 et g10 représentent indépendamment un nombre entier de 0 à 4, g6 à g9 représentent indépendamment un nombre entier de 0 à 6, les R₃₁ à R₃₅ peuvent être des groupes identiques ou différents lorsque g1 à g5 sont égaux à 2 ou plus, et les R₃₆ à R₄₀ peuvent être des groupes identiques ou
différents qui peuvent être liés ensemble pour former un cycle lorsque g6 à g10 sont égaux à 2 ou plus.

5. Dispositif de conversion photoélectrique selon l'une quelconque des revendications 1 à 4, dans lequel ledit colorant de complexe métallique comprend au moins un groupe de caractère acide.

6. Dispositif de conversion photoélectrique selon l'une quelconque des revendications 1 à 5, dans lequel ledit colorant de complexe métallique comprend au moins un groupe choisi dans le groupe constitué d'un groupe carboxyle, d'un groupe acide sulfonique, d'un groupe hydroxyle, d'un groupe acide hydroxamique, d'un groupe phosphoryle et d'un groupe phosphonyle.

7. Dispositif de conversion photoélectrique selon l'une quelconque des revendications 1 à 6, dans lequel lesdites particules de semi-conducteur sont des particules d'oxyde de titane.

8. Cellule photoélectrique comprenant ledit dispositif de conversion photoélectrique selon l'une quelconque des revendications 1 à 7.
